# EUROPEAN PATENT APPLICATION

(11) **EP 4 780 180 A1**
(43) Date of publication of application: **22.07.2026**
(21) Application number: 24865364.4
(22) Date of filing: 06.09.2024
(51) Int. Cl.: H10K 59/60, C09B 57/00, C09B 67/20, G02B 5/20, G02B 5/22, G09F 9/00, G09F 9/30, H10K 50/86, H10K 59/10, H10K 59/38, H10K 59/70, H10K 71/12

(54) **ORGANIC EL DISPLAY DEVICE, AND METHOD FOR MANUFACTURING SAME**

(30) Priority: 14.09.2023 JP 2023149493
(71) Applicant: Toppan Holdings Inc., Tokyo 110-8560 (JP)
(72) Inventor: HIGASHI, Mikako, Tokyo 110-8560 (JP); HARAGUCHI, Kazumichi, Tokyo 104-0031 (JP); KOGURE, Taketo, Tokyo 104-0031 (JP)
(74) Representative: Hoffmann Eitle
(86) International application number: PCT/JP2024/031958
(87) International publication number: WO 2025/057864

(57) **Abstract**

An organic EL display that includes an optical sensor, suppresses noise in the optical sensor, and is capable of achieving high resolution; and a method for manufacturing the same are provided. An organic EL display device including, on a substrate, a near-infrared light receiving portion, a lower electrode, a light emitting layer, a transparent electrode, and a color filter in this order, in which the color filter has a patterned colored layer and a visible-light shielding layer provided on the near-infrared light receiving portion, and a near-infrared light shielding layer on the colored layer, the near-infrared light shielding layer being located between the colored layer and the transparent electrode or integrated with the colored layer.

## Description

### [Technical Field]

The present disclosure relates to organic EL display devices and methods for manufacturing the same.

### [Background Art]

In recent years, in electronic devices such as mobile phones and personal digital assistants, display devices using organic electroluminescence (EL) elements, which are self-emitting have been developed and mass-produced to meet the demands for thinner, lighter, and/or curved devices, which have been difficult to achieve with the currently mainstream liquid crystal display devices. In particular, high expectations are placed on their application to small, high-resolution displays of around 0.5 inches (hereinafter referred to as microdisplays), such as head-mounted displays and electronic viewfinders, in order to take advantage of the thin and lightweight characteristics.

Meanwhile, there has been a growing demand for display devices that support biometric authentication technology in which automated devices extract specific biometric information or behavioral information from individuals to authenticate them, particularly in the fields of finance, healthcare, and mobile devices. In addition, head-mounted displays are increasingly required to incorporate eye-tracking functionality to mitigate VR sickness caused by out-of-focus images and to enhance the sense of immersion.

PTL 1 discloses an organic light-emitting diode (OLED) panel incorporating a near-infrared (NIR) organic photosensor, the OLED panel including a substrate, an OLED stack disposed on the substrate and emitting visible light, and an NIR photosensor stack disposed between the substrate and the OLED stack and including an NIR light-emitting portion that emits NIR light and an NIR light-receiving portion that receives NIR light

### [Citation List]

### [Patent Literature]

[PTL 1] JP 2019-033071 A

### [Summary of the Invention]

### [Technical Problem]

In the OLED panel of PTL 1, as will be described later, visible light may be incident on the organic NIR light-receiving portion. Furthermore, light emitted from the organic NIR light-emitting portion may pass through the pixel portion and then be emitted. This light forms noise and reduces the performance of the infrared sensor.

In addition, there is a demand for further reduction of pixel size in order to achieve higher resolution. Color-filter pixel formation is being considered because it is advantageous for forming fine pixels.

In consideration of the above-described problems, an object of the present disclosure is to provide an organic EL display device that includes an optical sensor, suppresses noise in the optical sensor, and is capable of achieving high resolution; and a method for manufacturing the same.

### [Solution to Problem]

An organic EL display device according to the present disclosure includes,
on a substrate, a near-infrared light receiving portion, a lower electrode, a light emitting layer, a transparent electrode, and a color filter in this order,
in which the color filter has a patterned colored layer and a visible-light shielding layer provided on the near-infrared light receiving portion, and
a near-infrared light shielding layer is provided on the colored layer, the near-infrared light shielding layer being located between the colored layer and the transparent electrode or integrated with the colored layer.

An aspect of the organic EL display device further includes
a near-infrared light emitting portion between the substrate and the lower electrode,
in which the color filter has a visible-light shielding layer provided on the near-infrared light emitting portion.

In an aspect of the organic EL display device, the near-infrared light shielding layer is provided on the colored layer.

In an aspect of the organic EL display device, the thickness of the visible-light shielding layer is greater than the total thickness of the colored layer and the near-infrared light shielding layer.

In an aspect of the organic EL display device, the visible-light shielding layer has a maximum light transmittance of 5% or less in the wavelength range of 400 to 620 nm, a maximum light transmittance of 13% or less in the wavelength range of 620 to 730 nm, and a minimum light transmittance of 85% or more in the wavelength range of 830 to 1000 nm.

In an aspect of the organic EL display device, the near-infrared light shielding layer has an average light transmittance of 80% or more in the wavelength range of 450 to 600 nm, a maximum absorption wavelength in the wavelength range of 780 to 1000 nm, and a light transmittance of 10% or less at the maximum absorption wavelength.

In an aspect of the organic EL display device, the visible-light shielding layer is a cured product of a visible-light shielding layer composition containing an organic pigment (A), a binder resin (B), a photoinitiator (C), and a photopolymerizable compound (D),
the organic pigment (A) contains a blue pigment, a yellow pigment, and a violet pigment, and
the content of the blue pigment is 32 to 45% by weight, the content of the yellow pigment is 30 to 40% by weight, and the content of the violet pigment is 20 to 30% by weight, relative to the organic pigment (A).

In an aspect of the organic EL display device, the near-infrared light shielding layer is a cured product of a near-infrared light shielding layer composition containing a near-infrared-light-absorbing dye (E) represented by the following general formula (1), a resin-type dispersant (F) having an amine value of 20 mgKOH/g to 200 mgKOH/g, and a binder resin (G) having a weight-average molecular weight of 5,000 to 40,000 and an acid value of 100 mgKOH/g to 130 mgKOH/g. 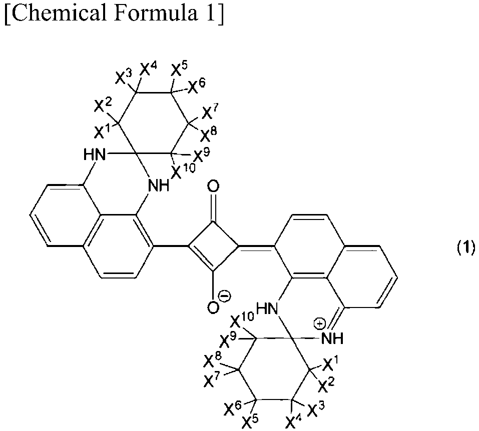
X¹ to X¹⁰ each independently represent a hydrogen atom, an alkyl group which may have one or more substituents, an alkenyl group which may have one or more substituents, an aryl group which may have one or more substituents, an aralkyl group which may have one or more substituents, an alkoxy group which may have one or more substituents, an aryloxy group which may have one or more substituents, an amino group, a substituted amino group, a sulfo group, - SO₂NR¹R², -COOR¹, -CONR¹R², a nitro group, a cyano group, or a halogen atom, and X¹ to X¹⁰ may be bonded to each other to form a ring.
R¹ and R² each independently represent a hydrogen atom or an alkyl group which may have one or more substituents.

A method for manufacturing an organic EL display device according to the present disclosure is characterized in that
the colored layer, the visible-light shielding layer, and the near-infrared light shielding layer are formed at 120°C or lower.

An aspect of the method for manufacturing an organic EL display device includes preparing a laminated substrate including a substrate and a near-infrared light receiving portion, a lower electrode, a light emitting layer, and a transparent electrode provided on the substrate, and
forming a coating film of a colored layer composition on the laminated substrate.

### [Advantageous Effects of the Invention]

According to the present disclosure, an organic EL display that includes an optical sensor, suppresses noise in the optical sensor, and is capable of achieving high resolution; and a method for manufacturing the same can be provided.

### [Brief Description of the Drawings]

Fig. 1 is a schematic cross-sectional view showing an aspect of the present organic EL display device.
Fig. 2 is a schematic cross-sectional view showing an aspect of the present organic EL display device.
Fig. 3 is a schematic cross-sectional view showing an aspect of the present organic EL display device.
Fig. 4 is a schematic cross-sectional view showing an aspect of the present organic EL display device.
Fig. 5 is a schematic cross-sectional view showing an aspect of the present organic EL display device.
Fig. 6 is a schematic plan view showing an aspect of the present organic EL display device.
Fig. 7 is a schematic plan view showing an aspect of the present organic EL display device.
Fig. 8 is a schematic plan view showing an aspect of the present organic EL display device.
Fig. 9 shows the transmittance spectrum of the visible-light shielding layer of Production Example 1.
Fig. 10 shows the transmittance spectrum of the near-infrared light shielding layer of Production Example 2.

### [Description of the Embodiments]

Organic EL display devices and methods for manufacturing them will be described.

For clarity of explanation, the following description and drawings have been appropriately simplified. For illustrative purposes, the components in the drawings may significantly differ in scale. In each drawing, the same elements are denoted by the same reference numerals, and repeated explanations are omitted as appropriate. In each drawing, the surface on the +Z side is the display surface (front) of the organic EL display device.

Terms used herein to specify shapes, geometric conditions, and their degrees, such as "parallel", "perpendicular", "orthogonal", and "identical", are not to be construed as being limited to their strict meanings, but rather as encompassing a range within which similar functions can be expected.

In the present disclosure, the use of "to" to indicate a range of values means that the values appearing before and after it are included as the lower and upper limits.

In the present disclosure, "(meth)acrylate" is a comprehensive term for acrylate and methacrylate, and the same applies to "(meth)acrylic" and the like.

Furthermore, in the present disclosure, "C. I." means color index.

### 1. Organic EL Display Device

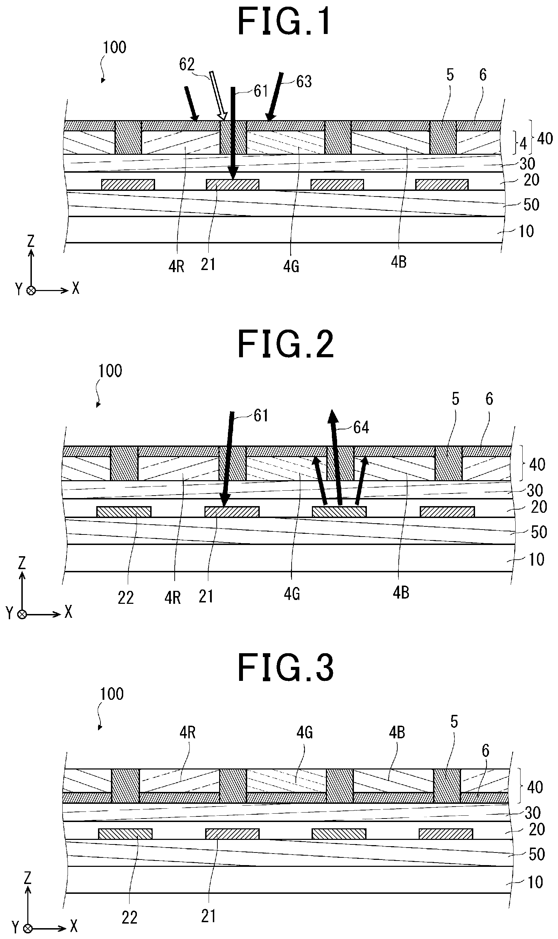

With reference to Fig. 1, a configuration of an organic EL display device according to a first embodiment will be described. An organic EL display device 100 shown in the example of Fig. 1 has, on a substrate 10, a near-infrared light receiving portion 21, an organic EL layer 30, and a color filter 40, in this order. The color filter 40 has a patterned colored layer 4 (4R, 4G, and 4B), a visible-light shielding layer 5 provided on the near-infrared light receiving portion 21, and a near-infrared light shielding layer 6 provided on the colored layer 4. Although not illustrated, the organic EL layer 30 includes a lower electrode, a light emitting layer, and a transparent electrode. In the example of Fig. 1, the substrate 10 includes a wiring layer 50. The wiring layer 50 includes wiring that electrically connects electrodes formed on the substrate with the near-infrared light receiving portion 21 and the organic EL layer 30. The wiring layer 50, the visible-light shielding layer 5, and the color filter 40 may have a coating film 20 for planarization or insulation. In the example of Fig. 1, the visible-light shielding layer 5 has the coating film 20.

The organic EL display device of the first embodiment has the visible-light shielding layer 5 on the near-infrared light receiving portion 21 and the near-infrared light shielding layer 6 on the colored layer 4. Therefore, visible light 62 incident from the display surface side and near-infrared light 63 with a large angle of incidence are absorbed by the respective layers. As a result, the incidence of noise-causing light on the near-infrared light receiving portion 21 is reduced, and near-infrared light 61 with a small angle of incidence can be received efficiently.

In the organic EL display device of the first embodiment, the photosensor is used as a transmissive photosensor, a reflective photosensor in combination with an external light source, or the like.

Next, with reference to Fig. 2, a configuration of an organic EL display device according to a second embodiment will be described. An organic EL display device 100 shown in the example of Fig. 2 has, on a substrate 10, a near-infrared light receiving portion 21 and a near-infrared light emitting portion 22, an organic EL layer 30, and a color filter 40, in this order. The color filter 40 has a patterned colored layer 4 (4R, 4G, and 4B), a visible-light shielding layer 5 provided on the near-infrared light receiving portion 21, and a near-infrared light shielding layer 6 provided on the colored layer 4.

The organic EL display device of the second embodiment has the configuration of the first embodiment, and in addition, includes the visible-light shielding layer 5 on the near-infrared light emitting portion 22 and the near-infrared light shielding layer 6 on the colored layer 4. Therefore, among near-infrared light emitted from the near-infrared emitting portion 22, that with a large emission angle is absorbed by the near-infrared light shielding layer 6, and only near-infrared light 64 with a small emission angle is emitted. As a result, the near-infrared light receiving portion 21 can efficiently receive the light reflected from a specimen.

In the organic EL display device of the second embodiment, the photosensor is mainly used as a reflective photosensor or the like.

Unless otherwise specified, the following description applies to both the organic EL display devices of the first and second embodiments.

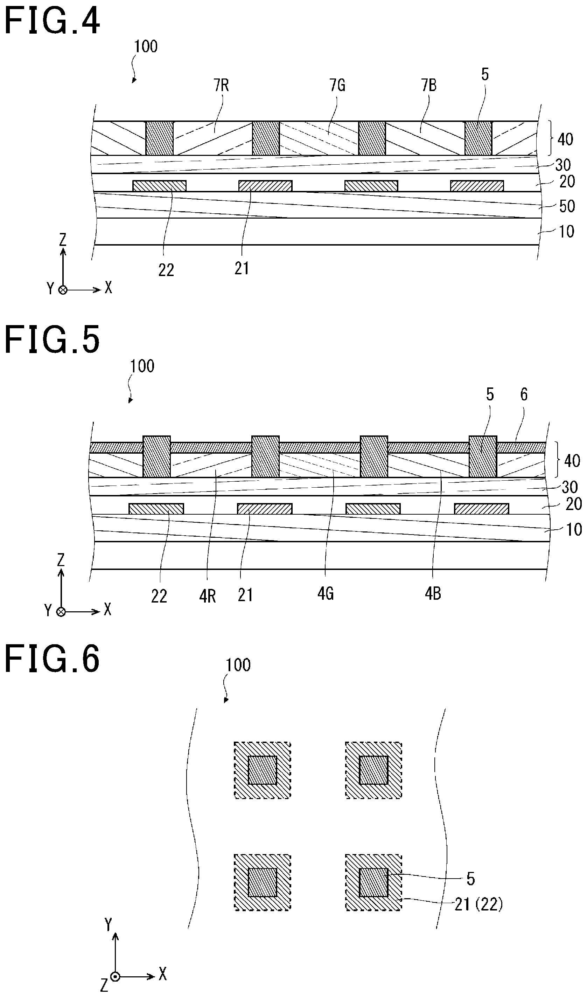

Figs. 3 and 4 show modifications of the color filter 40. An organic EL display device 100 in Fig. 3 includes the near-infrared light shielding layer 6 between a transparent electrode of the organic EL layer 30 and the colored layer 4. An organic EL display device 100 shown in Fig. 4 includes a colored layer 7 having near-infrared light shielding properties, in which the colored layer 4 and the near-infrared light shielding layer 6 are integrated. The organic EL display devices shown in Figs. 3 and 4 have the same advantageous effects as the organic EL display devices of the first and second embodiments.

Fig. 5 shows another modification of the color filter 40. In the color filter 40 of Fig. 5, the thickness of the visible-light shielding layer 5 is greater than the total thickness of the colored layer 4 and the near-infrared light shielding layer 6 (in the case of a near-infrared-light-shielding colored layer 7, the thickness of the colored layer 7). This configuration prevents the colored layer (4 or 7) or the near-infrared light shielding layer 6 from covering the visible-light shielding layer 5 during manufacturing, thereby stabilizing the quality of the organic EL display device. The thickness of the visible-light shielding layer 5 may be, for example, 10 to 1000 nm, preferably 20 to 200 nm, and more preferably 25 to 150 nm thicker than the total thickness of the colored layer 4 and the near-infrared light shielding layer 6.

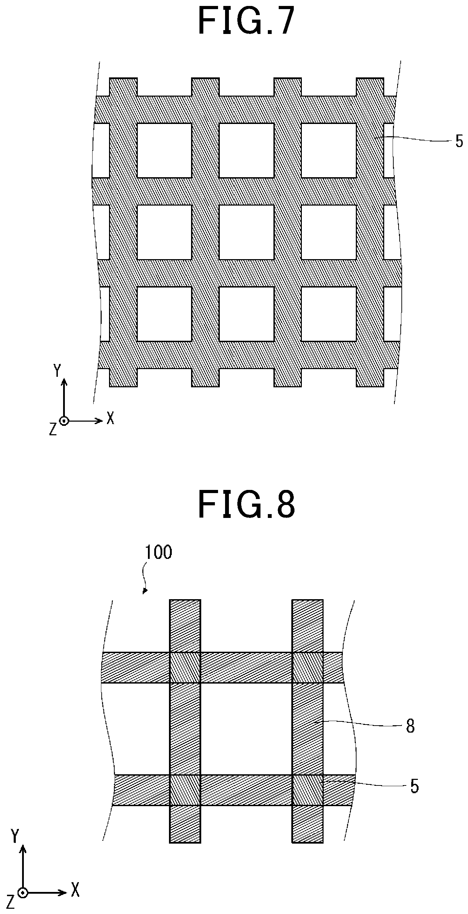

Next, the arrangement of the visible-light shielding layer 5 will be described with reference to Figs. 6 to 8. Figs. 6 to 8 are each a plan view (view from the +Z side) of an organic EL display device 100. As shown in Fig. 6, a plurality of visible-light shielding layers 5 may be disposed on at least parts of the near-infrared light receiving portion 21 and the near-infrared light emitting portion 22. The visible-light shielding layer 5 may also be formed in a lattice pattern as shown in Fig. 7. The visible-light shielding layer 5 in Fig. 7 also serves as a black matrix. As shown in Fig. 8, the black matrix may be formed by combining a plurality of visible-light shielding layers 5 with another light shielding layer 8.

The organic EL display devices of the first and second embodiments may further include other layers or components as necessary. The components of the organic EL display devices will be described in more detail in the following.

### [Near-Infrared Light Receiving Portion]

The near-infrared light receiving portion 21 is a portion that converts near-infrared light into an electrical signal. The near-infrared light receiving portion is, for example, a photodiode, preferably one that receives near-infrared light with a wavelength of 800 to 1500 nm. The organic EL display device may include at least one near-infrared light receiving portion, but preferably includes a plurality of near-infrared light receiving portions, and more preferably has them arranged in a lattice pattern. When a plurality of near-infrared receiving portions are provided, it is possible to obtain a mapping image of the measurement target (for example, a fingerprint, retina, face, or the like), which can be used for biometric authentication, etc.

### [Near-Infrared Light Emitting Portion]

The near-infrared light emitting portion 22 is a portion that emits near-infrared light. The near-infrared light emitting portion is, for example, a light-emitting diode, preferably one that emits near-infrared light with a wavelength of 800 to 1500 nm. The organic EL display device may include at least one near-infrared light emitting portion, but preferably includes a plurality of near-infrared light emitting portions, and more preferably they are arranged in a lattice pattern.

### [Color Filter]

In the present disclosure, the color filter includes a laminate of the colored layer 4 and the near-infrared light shielding layer 6 arranged in a pattern, or the near-infrared-light-shielding colored layer 7, and the visible-light shielding layer 5 arranged at the predetermined locations. The color filter is disposed directly on the organic EL layer 30 or via another layer.

### <Colored Layer>

The colored layer 4 includes at least a red layer 4R, a green layer 4G, and a blue layer 4B, and may further include a yellow layer, a cyan layer, a magenta layer, a white (colorless) layer, and the like.

The pattern arrangement of the colored layers is not particularly limited, and examples thereof include a stripe arrangement, a delta arrangement, a mosaic arrangement, and a honeycomb arrangement. The visible-light shielding layer 5 is arranged in at least a part of the color filter. A black matrix including the visible-light shielding layer 5 may be provided between the colored layers.

The area of each colored layer per section is preferably 1 to 50 µm², more preferably 1 to 30 µm², from the perspective of achieving high definition. The thickness of each colored layer is preferably 0.1 to 5 µm, more preferably 0.2 to 4 µm, from the perspective of color reproducibility.

In order to obtain an organic EL display device with high brightness, high resolution, and good color reproducibility, it is preferable that each colored layer has the following spectral characteristics.

Red layer: The maximum transmittance of light in the wavelength range of 450 to 560 nm is 0.5% or less, the 50% transmittance wavelength is 593 to 603 nm, and the average transmittance of light in the wavelength range of 600 to 700 nm is 80% or more and 100% or less.

Green layer: The maximum transmittance of light in the wavelength range of 400 to 470 nm is 2% or less, the maximum transmittance of light in the wavelength range of 525 to 535 nm is 67% or more, the 50% transmittance wavelength on the shorter wavelength side is 497 to 507 nm, and the 50% transmittance wavelength on the longer wavelength side is 554 to 581 nm.

Blue layer: The maximum transmittance of light in the wavelength range of 500 nm to 560 nm is less than 20%.

### <Visible-Light Shielding Layer>

The visible-light shielding layer 5 is a layer that absorbs visible light and preferably transmits near-infrared light. The visible-light shielding layer 5 preferably has, for example, the following spectral characteristics.
- The maximum light transmittance in the wavelength range of 400 to 620 nm is 5% or less.
- The maximum light transmittance in the wavelength range of 620 to 730 nm is 13% or less.
- The maximum light transmittance in the wavelength range of 830 to 1000 nm is 85% or more.

<Near-Infrared Light Shielding Layer>

The near-infrared light shielding layer 6 is a layer that absorbs near-infrared light and preferably transmits visible light. The near-infrared light shielding layer 6 preferably has, for example, the following spectral characteristics.
- The average light transmittance in the wavelength range of 450 to 600 nm is 80% or more.
- The maximum absorption wavelength is in the wavelength range of 780 to 1000 nm, and the light transmittance at the maximum absorption wavelength is 10% or less.

### <Material of Each Layer>

Next, the materials of the layers making up the color filter will be described. For example, when the organic EL display device is used in a high-definition microdisplay with a pixel size of 1 µm to 5 µm, each layer is preferably formed by photolithography, since this enables further miniaturization.

Furthermore, when the organic EL element and the color filter are formed on separate substrates and then bonded together, there is a risk of misalignment, which has a significant effect particularly in microdisplays. Therefore, it is preferable to form the color filter directly on the organic EL element. When the color filter is formed by such an on-chip method, it is necessary to form a sufficiently hardened layer by baking at 120°C or lower due to the heat resistance of the light emitting layer and the like.

The compositions for forming the layers that satisfy these conditions will be described below.

### (1) Visible-Light Shielding Layer Composition

A visible-light shielding layer composition contains an organic pigment (A), a binder resin (B), a photoinitiator (C), and a photopolymerizable compound (D);
the organic pigment (A) contains a blue pigment, a yellow pigment, and a violet pigment,
   and
the content of each organic pigment, relative to the organic pigment (A), is preferably 32 to 45% by weight for the blue pigment, 30 to 40% by weight for the yellow pigment, and 20 to 30% by weight for the violet pigment. The content of each pigment in the organic pigment (A) is more preferably 33 to 38% by weight for the blue pigment, 35 to 40% by weight for the yellow pigment, and 25 to 30% by weight for the violet pigment. Such a composition satisfies the above-mentioned spectral characteristics and film-forming conditions.

### (Organic Pigment (A))

The organic pigment (A) contains at least a blue pigment, a yellow pigment, and a violet pigment, and may further contain pigments of other colors.

Specific examples of blue pigments include C. I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79.

Specific examples of yellow pigments include C. I. Pigment Yellow (PY) 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136 , 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208.

Specific examples of violet pigments include C. I. Pigment Violet (PV) 1, 1:1, 2, 2:2, 3, 3:1, 3:3, 5, 5:1, 14, 15, 16, 19, 23, 25, 27, 29, 31, 32, 37, 39, 42, 44, 47, 49, and 50.

In the organic pigment (A) used in the visible-light shielding layer composition, the blue pigment is preferably C. I. Pigment Blue 15, 15:1, 15:2, 15:3, 15:4, or 15:6, and more preferably C. I. Pigment Blue 15:3 or 15:6, from the perspective of visible-light-shielding properties. In the organic pigment (A), the yellow pigment is preferably C. I. Pigment Yellow 83, 117, 129, 138, 139, 150, 154, 155, 180, or 185, and more preferably C. I. Pigment Yellow 83, 138, 139, 150, or 185, from the perspective of visible-light-shielding properties.

In addition, in the organic pigment (A), the violet pigment is preferably C. I. Pigment Violet 19 or 23, and more preferably C. I. Pigment Violet 23, from the perspective of visible-light-shielding properties.

From the perspective of obtaining sufficient light-shielding properties, the total concentration of the organic pigment (A) in the visible-light shielding layer composition is preferably 10 to 90% by weight, more preferably 15 to 85% by weight, and even more preferably 20 to 80% by weight, relative to the non-volatile components in the visible-light shielding layer composition.

The organic pigment (A) is preferably used in a micronized form. The organic pigment (A) preferably has a primary particle size of 20 to 100 nm, more preferably from 25 to 85 nm. The primary particle size of the pigment is measured by directly measuring the size of primary particles in a TEM (transmission electron microscope) electron micrograph of the pigment. Specifically, the minor-axis and major-axis diameters of a primary pigment particle are measured, and the average is taken as the particle size of that pigment particle. This is obtained for 100 or more pigment particles, and the average is taken as the average primary particle size.

### (Binder Resin (B))

The binder resin (B) contributes to the dispersion stability of the organic pigment (A) and suppresses its aggregation in the visible-light shielding layer. Furthermore, by using the binder resin (B), developability and shape stability in photolithography can be improved.

The binder resin (B) is preferably a thermoplastic resin, and when the visible-light shielding layer composition is an alkali-developable resist, it is preferably an alkali-soluble resin having an acidic group. In order to further improve photosensitivity, the binder resin (B) may be an active energy ray-curable resin having an ethylenically unsaturated double bond. In particular, it is preferably an alkali-soluble active energy ray-curable resin.

As a thermoplastic resin, for example, acrylic resin, butyral resin, styrene-maleic acid copolymer, chlorinated polyethylene, chlorinated polypropylene, polyvinyl chloride, polyvinyl chloride-vinyl acetate copolymer, polyvinyl acetate, polyurethane-based resin, polyester resin, vinyl resin, alkyd resin, polystyrene resin, polyamide resin, rubber-based resin, cyclized rubber-based resin, cellulose compounds, polyethylene (HDPE, LDPE), polybutadiene, polyimide resin or the like can be employed. In particular, it is preferably an acrylic resin.

The acidic group in the alkali-soluble resin may be a carboxy group, a sulfo group, or the like. Specific examples of the alkali-soluble resin include an acrylic resin having an acidic group, an α-olefin/maleic acid (anhydride) copolymer, a styrene/styrene sulfonic acid copolymer, an ethylene/(meth)acrylic acid copolymer, and an isobutylene/maleic acid (anhydride) copolymer. Among these, an acrylic resin having an acidic group and a styrene/styrene sulfonic acid copolymer are preferred, and an acrylic resin having an acidic group is more preferred from the perspective of heat resistance and transparency.

Examples of the alkali-soluble active energy ray-curable resin include resins produced by the following methods (i) and (ii).

Method (i): A carboxylic acid having an ethylenically unsaturated double bond undergoes an addition reaction with a side-chain epoxy group of a copolymer obtained by copolymerizing an epoxy-group-containing monomer with another monomer, and the resulting hydroxyl group is reacted with a polycarboxylic acid (anhydride) to introduce an ethylenically unsaturated double bond and a carboxy group.

Examples of the epoxy-group-containing monomer include glycidyl (meth)acrylate, methyl glycidyl (meth)acrylate, 2-glycidoxyethyl (meth)acrylate, 3,4-epoxybutyl (meth)acrylate, and 3,4-epoxycyclohexyl (meth)acrylate, and from the perspective of reactivity with a carboxylic acid having an ethylenically unsaturated double bond in the next step, glycidyl (meth)acrylate is preferred.

Examples of the carboxylic acid having an ethylenically unsaturated double bond include (meth)acrylic acid, crotonic acid, and vinylbenzoic acid.

The polycarboxylic acid may be an anhydride, and examples thereof include tetrahydrophthalic anhydride, phthalic anhydride, hexahydrophthalic anhydride, succinic anhydride, maleic anhydride, trimellitic anhydride, and pyromellitic dianhydride.

As a modification of the method (i), a compound having an ethylenically unsaturated double bond and an epoxy group may be added to a side chain carboxy group of a copolymer obtained by copolymerizing a carboxy-group-containing monomer with another monomer, and the resulting hydroxyl group may be reacted with a polycarboxylic acid (anhydride) to introduce an ethylenically unsaturated double bond and a carboxy group.

Method (ii): A hydroxyl-group-containing monomer, a carboxyl-group-containing monomer, and, if necessary, other monomers are copolymerized to obtain a copolymer, and an ethylenically unsaturated monomer having an isocyanate group is reacted with a side chain hydroxyl group of the copolymer to introduce an ethylenically unsaturated double bond.

Examples of the hydroxyl-group-containing monomer include hydroxyalkyl (meth)acrylates such as 2-hydroxyethyl (meth)acrylate, hydroxypropyl (meth)acrylate, hydroxybutyl (meth)acrylate, glycerol (meth)acrylate, and cyclohexanedimethanol mono(meth)acrylate. Further examples include polyether mono(meth)acrylates obtained by adding ethylene oxide, propylene oxide, and/or butylene oxide to the above-mentioned hydroxyalkyl (meth)acrylates; and (poly)ester mono(meth)acrylates obtained by adding (poly)γ-valerolactone, (poly)ε-caprolactone, (poly)12-hydroxystearic acid, and/or the like to the above-mentioned hydroxyalkyl (meth)acrylates. From the perspective of suppressing the generation of foreign matter in a coating film formed using the material, 2-hydroxyethyl (meth)acrylate or glycerol (meth)acrylate is preferred.

Examples of the carboxy-group-containing monomer include those described above for the carboxylic acid having an ethylenically unsaturated double bond.

Examples of the isocyanate-group-containing monomer include 2-(meth)acryloyloxyethyl isocyanate and 1,1-bis[(meth)acryloyloxy]ethyl isocyanate.

The weight-average molecular weight (Mw) of the binder resin (B) is preferably in the range of 10,000 to 100,000, more preferably 10,000 to 80,000, from the perspective of the dispersibility of the organic pigment (A) and the like. The number-average molecular weight (Mn) is preferably in the range of 5,000 to 50,000, and the value of Mw/Mn is preferably 10 or less.

The acid value of the binder resin (B) is preferably 20 to 300 mgKOH/g from the perspectives of pigment dispersibility, developability, and resistance of the cured film.

The proportion of the binder resin (B) in the visible-light shielding layer composition is preferably 20 to 1000 parts by weight relative to 100 parts by weight of the organic pigment (A) from the perspectives of film formation properties and durability of the cured film.

### (Photoinitiator (C))

Examples of the photoinitiator (C) include acetophenone-based compounds such as 4-phenoxydichloroacetophenone, 4-t-butyl-dichloroacetophenone, diethoxyacetophenone, p-dimethylaminoacetophenone, 1-(4-isopropylphenyl)-2-hydroxy-2-methylpropan-1-one, 1-hydroxycyclohexyl phenyl ketone, 2-methyl-1-[4-(methylthio)phenyl]-2-morpholinopropan-1-one, 2-benzyl-2-dimethylamino-1-(4-morpholinophenyl)-butan-1-one, and 2-(dimethylamino)-2-[(4-methylphenyl)methyl]-1-[4-(4-morpholinyl)phenyl]-1-butanone;
benzoin-based compounds such as benzoin, benzoin methyl ether, benzoin ethyl ether, benzoin isopropyl ether, and benzil dimethyl ketal;
benzophenone-based compounds such as benzophenone, benzoylbenzoic acid, methyl benzoylbenzoate, 4-phenylbenzophenone, hydroxybenzophenone, acrylated benzophenone, 4-benzoyl-4'-methyldiphenyl sulfide, and 3,3',4,4'-tetra(t-butylperoxycarbonyl)benzophenone;
thioxanthone-based compounds such as thioxanthone, 2-chlorothioxanthone, 2-methylthioxanthone, isopropylthioxanthone, 2,4-diisopropylthioxanthone, and 2,4-diethylthioxanthone;
triazine-based compounds such as 2,4,6-trichloro-s-triazine, 2-phenyl-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-piperonyl-4,6-bis(trichloromethyl)-s-triazine, 2,4-bis(trichloromethyl)-6-styryl-s-triazine, 2-(naphth-1-yl)-4,6-bis(trichloromethyl)-s-triazine, 2-(4-methoxy-naphth-1-yl)-4,6-bis(trichloromethyl)-s-triazine, 2,4-trichloromethyl-(piperonyl)-6-triazine, and 2,4-trichloromethyl(4'-methoxystyryl)-6-triazine;
acetophenone, benzophenone, 4,4'-bis(diethylamino)-benzophenone, 4-(methylphenylthio)-phenyl phenyl ketone, benzil dimethyl ketal, 2-methyl-1-methylthiophenyl-2-morpholinopropan-1-one, 2-benzyl-2-dimethylamino-1-(4-morpholinophenyl)butan-1-one, ethyl p-diethylaminobenzoate, thioxanthone, 2,5-diethylthioxanthone, 2-chloroxanthone, isopropylthioxanthone, 1-chloro-4-propoxy-thioxanthone, 2-(o-chlorophenyl)-4,5-diphenylimidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, 2-(o-chlorophenyl)-4,5-di(o-methoxyphenyl)imidazole dimer, 9-phenylacridine, 9-(p-toluyl)acridine, 1,7-bis(9,9'-acridinyl)heptane, N-phenylglycine, bis(η5-cyclopentadienyl)bis[2,6-difluoro-3-(1H-pyrrol-1-yl)phenyl]titanium, 2-ethylanthrene anthraquinone, 1-chloroanthraquinone, 2-phenyl-4,6-bis(trichloromethyl)-s-triazine, 2-(4-methoxyphenyl)-4,6-bis(trichloromethyl)-s-triazine, 2-naphthyl-4,6-bis(trichloromethyl)-s-triazine, 2-(4-methoxynaphthyl)-4,6-bis(trichloromethyl)-s-triazine, 2-methyl-4,6-bis(trichloromethyl)-s-triazine, 1,2-octanedione, oxime ester compounds such as 1-[4-(phenylthio)phenyl-2-(O-benzoyloxime)] and O-(acetyl)-N-(1-phenyl-2-oxo-2-(4'-methoxynaphthyl)ethylidene)hydroxylamine; phosphine-based compounds such as bis(2,4,6-trimethylbenzoyl)phenylphosphine oxide and 2,4,6-trimethylbenzoyl-diphenyl-phosphine oxide; imidazole-based compounds such as 2,2'-bis(o-chlorophenyl)-4,5,4',5'-tetraphenyl-1,2'-biimidazole, 2,2'-bis(o-methoxyphenyl)-4,4',5,5'-tetraphenylbiimidazole, and 2,2'-bis(o-chlorophenyl)-4,4',5,5'-tetra(p-methylphenyl)biimidazole;
aminoketone compounds such as 2-dimethylamino-2-methyl-1-phenylpropan-1-one, 2-diethylamino-2-methyl-1-phenylpropan-1-one, 2-methyl-2-morpholino-1-phenylpropan-1-one, 2-dimethylamino-2-methyl-1-(4-methylphenyl)propan-1-one, 2-dimethylamino-1-(4-ethylphenyl)-2-methylpropan-1-one, 2-dimethylamino-1-(4-isopropylphenyl)-2-methylpropan-1-one, 1-(4-butylphenyl)-2-dimethylamino-2-methylpropan-1-one, 2-dimethylamino-1-(4-methoxyphenyl)-2-methylpropan-1-one, 2-dimethylamino-2-methyl-1-(4-methylthiophenyl)propan-1-one, 2-methyl-1-(4-methylthiophenyl)-2-morpholinopropan-1-one (IRGACURE 907), 2-benzyl-2-dimethylamino-1-(4-morpholinophenyl)-butan-1-one (IRGACURE 369), 2-benzyl-2-dimethylamino-1-(4-dimethylaminophenyl)-butan-1-one, 2-dimethylamino-2-[(4-methylphenyl)methyl]-1-[4-(4-morpholinyl)phenyl]-1-butanone (IRGACURE 379);
quinone-based compounds such as 9,10-phenanthrenequinone, camphorquinone, and ethylanthraquinone; borate-based compounds, carbazole-based compounds, and titanocene-based compounds.

Among these, it is more preferable that an oxime ester-based compound is included as the photoinitiator. Oxime ester-based compounds have very high sensitivity, enabling pattern formation with low exposure doses, and also provide good adhesion in the development step.

Among oxime ester-based photoinitiators, those represented by the following general formulas (8) to (10) are preferred, those represented by the following general formula (8) or (9) are more preferred, and those represented by general formula (8) are even more preferred.

### - Oxime ester photoinitiator represented by general formula (8)

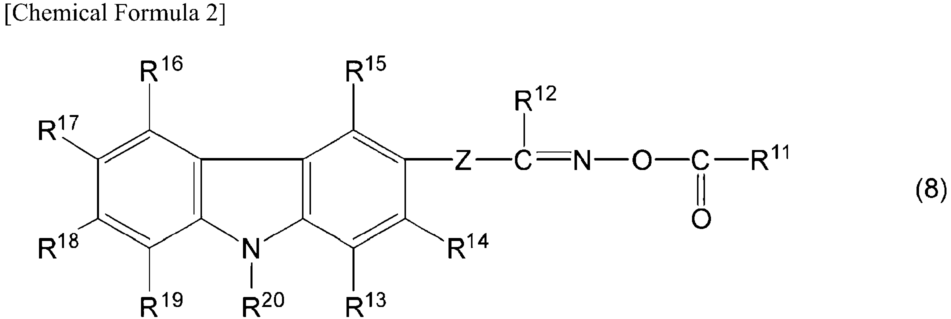

In formula (8), Z represents a direct bond or a -C(=O)- group, R¹¹ represents an alkyl group having 1 to 20 carbon atoms which may have one or more substituents, R¹² represents an alkyl group having 1 to 20 carbon atoms which may have one or more substituents, or an aryl group which may have one or more substituents, and R¹³ to R²⁰ each independently represent a hydrogen atom, an alkyl group having 1 to 20 carbon atoms which may have one or more substituents, an aryl group which may have one or more substituents, a nitro group, or an R²¹-C(=O)- group. R²¹ represents an aryl group which may have one or more substituents.

Examples of the alkyl group having 1 to 20 carbon atoms for R¹¹ to R²⁰ include straight-chain alkyl groups such as a methyl group, an ethyl group, a propyl group, a butyl group, a hexyl group, an octyl group, and a dodecyl group.

Examples of the aryl group for R¹² to R²¹ include a phenyl group, a naphthyl group, and an anthracenyl group.

The direct bond for Z means that Z does not have any atoms, and the two atoms connected to Z in general formula (8) are directly bonded.

The substituents that the alkyl group and aryl group may have mean that the alkyl or aryl group may have one or more substituents in place of a hydrogen atom in the alkyl or aryl group. Examples of the substituent include halogen atoms such as fluorine atom, chlorine atom, bromine atom, and iodine atom; alkoxy groups such as methoxy, ethoxy, and tert-butoxy; aryloxy groups such as phenoxy and p-tolyloxy; alkoxycarbonyl groups such as methoxycarbonyl, butoxycarbonyl, and phenoxycarbonyl; acyloxy groups such as acetoxy, propionyloxy, and benzoyloxy; acyl groups such as acetyl, benzoyl, isobutyryl, acryloyl, methacryloyl, and methoxalyl; alkylsulfanyl groups such as methylsulfanyl and tert-butylsulfanyl; arylsulfanyl groups such as phenylsulfanyl and p-tolylsulfanyl; alkylamino groups such as methylamino and cyclohexylamino; dialkylamino groups such as dimethylamino, diethylamino, morpholino, and piperidino; arylamino groups such as phenylamino and p-tolylamino; alkyl groups such as methyl, ethyl, tert-butyl, dodecyl, cyclopropyl, cyclobutyl, cyclopentyl, cyclohexyl, cycloheptyl, cyclooctyl, and cyclooctadecyl; aryl groups such as phenyl, p-tolyl, xylyl, cumenyl, naphthyl, anthryl, and phenanthryl; heterocyclic groups such as furyl and thienyl; and hydroxy group, carboxy group, formyl group, mercapto group, sulfo group, mesyl group, p-toluenesulfonyl group, amino group, nitro group, cyano group, trifluoromethyl group, trichloromethyl group, trimethylsilyl group, phosphinico group, phosphono group, trimethylammonium group, dimethylsulfoniumyl group, and triphenylphenacylphosphoniumyl group.

Furthermore, one or more substituents of one or more of these types may be present, and furthermore, the hydrogen atoms of these substituents may be further substituted with other substituents.

Among the oxime ester-based photoinitiators represented by general formula (8), it is preferable that Z is a direct bond or a -C(=O)- group, R¹¹ is an alkyl group having 1 to 20 carbon atoms which may have one or more substituents, R¹² is an alkyl group having 1 to 20 carbon atoms which may have one or more substituents, or an aryl group which may have one or more substituents, and R¹³ to R²⁰ each independently are a hydrogen atom, an alkyl group having 1 to 20 carbon atoms which may have one or more substituents, an aryl group which may have one or more substituents, a nitro group, or an R²¹-CO- group. In particular, it is more preferable that R¹⁴ to R¹⁶ and R¹⁸ to R²⁰ are hydrogen atoms, R¹⁷ is a hydrogen atom or an R²¹-CO- group, and R²¹ is an aryl group which may have one or more substituents.

Among the oxime ester-based photoinitiators represented by general formula (8), compounds represented by the following chemical formula (8-1) or (8-2) are preferred.

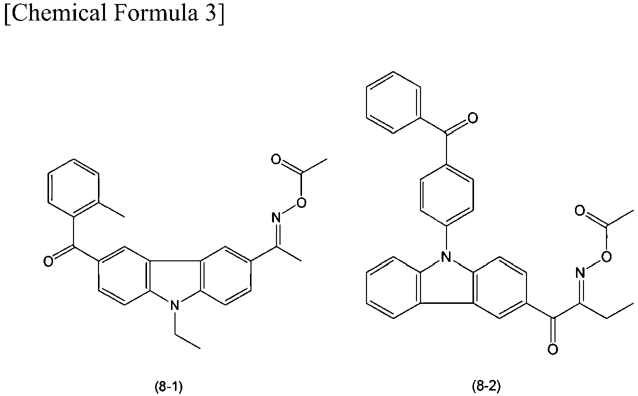

### - Oxime ester photoinitiator represented by general formula (9)

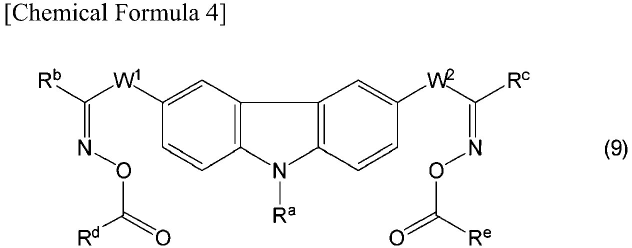

In formula (9), W¹ and W² each independently represent a carbonyl bond (-CO-) or a single bond, and at least one of W¹ and W² is a carbonyl bond (-CO-).

R^{a} is an alkyl group having 2 to 6 carbon atoms, R^{b} is an alkyl group having 4 to 10 carbon atoms, R^{c} is a group that has at least a hydrocarbon ring or a heterocycle and may further have at least one divalent linking group selected from an alkylene chain having 1 to 4 carbon atoms, a thioether bond (-S-), an ether bond (-O-), and a carbonyl bond (-CO-), and R^{b} and R^{c} are different substituents. R^{d} and R^{e} each independently represent an alkyl group having 1 to 6 carbon atoms.

Examples of the alkyl group for R^{a} include straight-chain alkyl groups such as an ethyl group, a propyl group, a butyl group, and a hexyl group.

Examples of the alkyl group for R^{b} include straight-chain alkyl groups such as a butyl group, a hexyl group, an octyl group, and a dodecyl group.

Examples of the hydrocarbon ring for R^{c} include an aliphatic hydrocarbon ring such as a cyclohexyl group, and an aromatic hydrocarbon ring such as a phenyl group, a naphthyl group, or an anthracenyl group. Furthermore, examples of the heterocyclic ring for R^{c} include rings in which one or more carbon atoms of the above hydrocarbon rings have been replaced with nitrogen atoms, oxygen atoms, and/or sulfur atoms.

Examples of the alkyl group for R^{d} and R^{e} include straight-chain alkyl groups such as a methyl group, an ethyl group, a propyl group, a butyl group, and a hexyl group.

Among the oxime ester-based photoinitiators represented by general formula (9), compounds represented by the following chemical formula (9-1) are preferred.

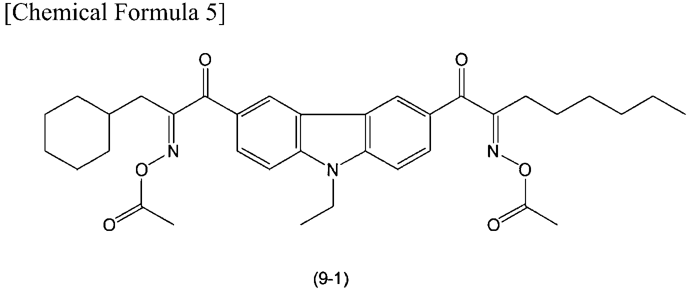

### - Oxime ester photoinitiator represented by general formula (10)

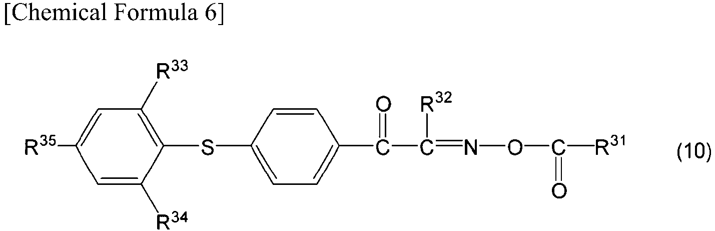

In formula (10), R³¹ and R³² are each independently a hydrogen atom, an alkyl group having 1 to 20 carbon atoms which may have one or more substituents, or an aryl group which may have one or more substituents; R³³ and R³⁴ are each independently a hydrogen atom, an alkyl group having 1 to 20 carbon atoms which may have one or more substituents, or an aryl group which may have one or more substituents; R³⁵ is a hydrogen atom, an alkyl group having 1 to 20 carbon atoms which may have one or more substituents, an aryl group which may have one or more substituents, or an R³⁶-CO- group; and R³⁶ is an alkyl group having 1 to 20 carbon atoms which may have one or more substituents, an aryl group which may have one or more substituents, or a heterocyclic group.

The alkyl group having 1 to 20 carbon atoms for R³¹ to R³⁶ can be the same as the alkyl group having 1 to 20 carbon atoms for R¹¹ to R²⁰ described above.

The aryl group for R³¹ to R³⁶ can be the same as the aryl group for R¹² to R²¹ described above.

Examples of the heterocyclic ring in the heterocyclic group of R³⁶ include furan, thiophene, pyrrole, oxazole, thiazole, imidazole, pyrazole, pyran, pyrone, pyridine, pyridazine, pyrimidine, pyrazine, benzofuran, thionaphthene, indole, carbazole, coumarin, quinoline, phthalazine, and quinoxaline.

The substituents that the alkyl group and aryl group may have may be the same as those in general formula (8).

In the oxime ester-based photoinitiator represented by general formula (10), R³¹ is preferably an aryl group which may have one or more substituents, R³² is an alkyl group having 1 to 20 carbon atoms which may have one or more substituents, R³³ and R³⁴ are hydrogen atoms, and R³⁵ is preferably a hydrogen atom or an R³⁶-CO- group.

Among the oxime ester-based photoinitiators represented by general formula (10), compounds represented by the following chemical formula (10-1) are preferred.

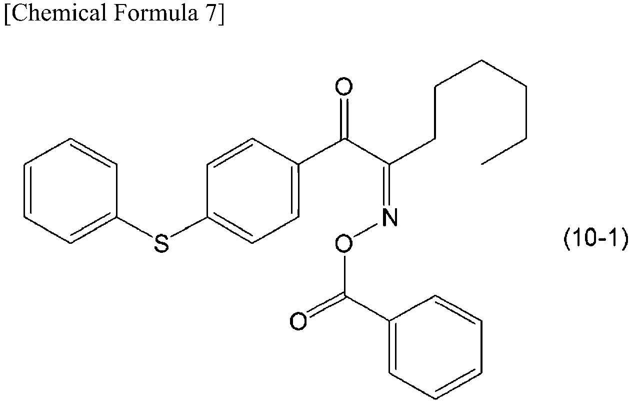

From the perspectives of curability and developability, the proportion of the photoinitiator (C) in the visible-light shielding layer composition is preferably 5 to 200 parts by weight, more preferably 10 to 150 parts by weight, relative to 100 parts by weight of the organic pigment (A).

### (Photopolymerizable Compound (D))

Examples of the photopolymerizable compound (D) include monomers and oligomers that are cured by exposure to ultraviolet light or the like to form a transparent resin. Specific examples of the photopolymerizable compound (D) include various acrylic acid esters and methacrylic acid esters such as methyl (meth)acrylate, ethyl (meth)acrylate, 2-hydroxyethyl (meth)acrylate, 2-hydroxypropyl (meth)acrylate, cyclohexyl (meth)acrylate, β-carboxyethyl (meth)acrylate, polyethylene glycol di(meth)acrylate, 1,6-hexanediol di(meth)acrylate, triethylene glycol di(meth)acrylate, tripropylene glycol di(meth)acrylate, trimethylolpropane tri(meth)acrylate, trimethylolpropane PO-modified tri(meth)acrylate, trimethylolpropane EO-modified tri(meth)acrylate, pentaerythritol tri(meth)acrylate, pentaerythritol tetra(meth)acrylate, 1,6-hexanediol diglycidyl ether di(meth)acrylate, bisphenol A diglycidyl ether di(meth)acrylate, neopentyl glycol diglycidyl ether di(meth)acrylate, dipentaerythritol hexa(meth)acrylate, dipentaerythritol penta(meth)acrylate, tricyclodecanyl (meth)acrylate, ester acrylate, (meth)acrylic acid ester of methylolated melamine, epoxy (meth)acrylate, and urethane acrylate; (meth)acrylic acid, styrene, vinyl acetate, hydroxyethyl vinyl ether, ethylene glycol divinyl ether, pentaerythritol trivinyl ether, (meth)acrylamide, N-hydroxymethyl (meth)acrylamide, N-vinylformamide, and acrylonitrile.

Further examples of the photopolymerizable compound (D) include an esterification product of a compound, in which (meth)acrylic acid is introduced into a part of a polyhydric alcohol, with a dicarboxylic acid; an esterification product of a polycarboxylic acid with a monohydroxy(meth)acrylate; and the like. Specific examples include monoesters of monohydroxy oligoacrylates or monohydroxy oligomethacrylates, such as trimethylolpropane diacrylate, trimethylolpropane dimethacrylate, pentaerythritol triacrylate, pentaerythritol trimethacrylate, dipentaerythritol pentaacrylate, and dipentaerythritol pentamethacrylate, with dicarboxylic acids, such as malonic acid, succinic acid, glutaric acid, and terephthalic acid; and esters of tricarboxylic acids, such as propane-1,2,3-tricarboxylic acid (tricarballylic acid), butane-1,2,4-tricarboxylic acid, benzene-1,2,3-tricarboxylic acid, benzene-1,3,4-tricarboxylic acid, and benzene-1,3,5-tricarboxylic acid, with monohydroxy monoacrylates or monohydroxy monomethacrylates, such as 2-hydroxyethyl acrylate, 2-hydroxyethyl methacrylate, 2-hydroxypropyl acrylate, and 2-hydroxypropyl methacrylate.

It may also be a polyfunctional monomer having 3 to 12 ethylenically unsaturated bonds in one molecule, and it preferably includes a polyfunctional monomer.

In addition to the above, examples of the polyfunctional monomer include phenoxytetraethylene glycol (meth)acrylate, phenoxyhexaethylene glycol (meth)acrylate, EO-modified phthalic acid (meth)acrylate, PO-modified phthalic acid (meth)acrylate, acrylated isocyanurate, bis(acryloxyneopentylglycol) adipate, polyethylene glycol 200 di(meth)acrylate, polyethylene glycol 400 di(meth)acrylate, tetraethylene glycol di(meth)acrylate, EO-modified trimethylolpropane triacrylate, PO-modified trimethylolpropane tri(meth)acrylate, tripropylene glycol di(meth)acrylate, tris(acryloxyethyl)isocyanurate, caprolactone-modified tris(acryloxyethyl)isocyanurate, neopentyl glycol hydroxypivalate di(meth)acrylate, pentaerythritol tri(meth)acrylate, dicyclopentanyl di(meth)acrylate, EO-modified bisphenol A di(meth)acrylate, dipentaerythritol hexa(meth)acrylate, dipentaerythritol monohydroxypenta(meth)acrylate, alkyl-modified dipentaerythritol penta(meth)acrylate, and caprolactone-modified dipentaerythritol hexa(meth)acrylate.

The photopolymerizable compound (D) may contain a compound represented by the following general formula (7) in order to achieve both good adhesion to other layers and high resolution of the resist pattern.

General formula (7): [CH₂=CHC(=O)-(OCₘH₂ₘ)ₙ-OCH₂]₃-CR

(In general formula (1), m represents an integer of 1 to 3, n represents an integer of 0 to 2, and the m's and n's may be the same or different.

R represents one or more substituents selected from -CH₂CH₃, -CH₂OH, and - CH₂OC(=O)C=CH₂.)

Examples of the compound represented by general formula (7) include trimethylolpropane triacrylate, trimethylolpropane EO-modified triacrylate, trimethylolpropane PO-modified triacrylate, pentaerythritol triacrylate, and pentaerythritol tetraacrylate.

From the perspectives of curability and developability, the proportion of the photopolymerizable compound (D) in the visible-light shielding layer composition is preferably 5 to 400 parts by weight, more preferably 10 to 300 parts by weight, relative to 100 parts by weight of the organic pigment (A).

### (Optional Components)

The visible-light shielding layer composition may further contain other components. Examples of the other components include sensitizers, solvents, chain transfer agents, antioxidants, leveling agents, storage stabilizers, adhesion improvers, ultraviolet absorbers, and polymerization inhibitors.

### - Sensitizer

Sensitizers improve the photocurability of the composition and the development stability of the cured product.

Examples of sensitizers include unsaturated ketones such as chalcone derivatives and dibenzalacetone; 1,2-diketone derivatives such as benzil and camphorquinone; polymethine dyes such as benzoin derivatives, fluorene derivatives, naphthoquinone derivatives, anthraquinone derivatives, xanthene derivatives, thioxanthene derivatives, xanthone derivatives, thioxanthone derivatives, coumarin derivatives, ketocoumarin derivatives, cyanine derivatives, merocyanine derivatives, and oxonol derivatives; acridine derivatives, azine derivatives, thiazine derivatives, oxazine derivatives, indoline derivatives, azulene derivatives, azulenium derivatives, squarylium derivatives, porphyrin derivatives, tetraphenylporphyrin derivatives, triarylmethane derivatives, tetrabenzoporphyrin derivatives, tetrapyrazinoporphyrazine derivatives, phthalocyanine derivatives, tetraazaporphyrazine derivatives, tetraquinoxalylporphyrazine derivatives, naphthalocyanine derivatives, subphthalocyanine derivatives, pyrylium derivatives, thiopyrylium derivatives, tetraphyrin derivatives, annulene derivatives, spiropyran derivatives, spirooxazine derivatives, thiospiropyran derivatives, metal arene complexes, organic ruthenium complexes, and Michler's ketone derivatives Among these, thioxanthone derivatives, Michler's ketone derivatives, and carbazole derivatives are preferred as the sensitizer, and more specifically, 2,4-diethylthioxanthone, 2-chlorothioxanthone, 2,4-dichlorothioxanthone, 2-isopropylthioxanthone, 4-isopropylthioxanthone, 1-chloro-4-propoxythioxanthone, 4,4'-bis(dimethylamino)benzophenone, 4,4'-bis(diethylamino)benzophenone, 4,4'-bis(ethylmethylamino)benzophenone, N-ethylcarbazole, 3-benzoyl-N-ethylcarbazole, and 3,6-dibenzoyl-N-ethylcarbazole are preferred.

When a sensitizer is used, it is preferably contained in an amount of 3 to 60 parts by weight, more preferably 5 to 50 parts by weight, relative to 100 parts by weight of the photoinitiator (C) from the perspectives of curability and developability.

### - Solvent

The solvent improves the dispersibility of the organic pigment (A) and the coating and film-forming properties of the composition.

Examples of solvents include ester solvents (solvents containing -COO- but not -O- in the molecule), ether solvents (solvents containing -O- but not -COO- in the molecule), ether ester solvents (solvents containing -COO- and -O- in the molecule), ketone solvents (solvents containing -CO- but not -COO- in the molecule), alcohol solvents (solvents containing OH in the molecule but not -O-, -CO-, or -COO-), aromatic hydrocarbon solvents, amide solvents, and dimethyl sulfoxide.

Specific examples of solvents include 1,2,3-trichloropropane, 1,3-butanediol, 1,3-butylene glycol, 1,3-butylene glycol diacetate, 1,4-dioxane, 2-heptanone, 2-methyl-1,3-propanediol, 3,5,5-trimethyl-2-cyclohexen-1-one, 3,3,5-trimethylcyclohexanone, ethyl 3-ethoxypropionate, 3-methyl-1,3-butanediol, 3-methoxy-3-methyl-1-butanol, 3-methoxy-3-methylbutyl acetate, 3-methoxybutanol, 3-methoxybutyl acetate, 4-heptanone, m-xylene, m-diethylbenzene, m-dichlorobenzene, N,N-dimethylacetamide, N,N-dimethylformamide, n-butyl alcohol, n-butylbenzene, n-propyl acetate, N-methylpyrrolidone, o-xylene, o-chlorotoluene, o-diethylbenzene, o-dichlorobenzene, p-chlorotoluene, p-diethylbenzene, sec-butylbenzene, tert-butylbenzene, γ-butyrolactone, isobutyl alcohol, isophorone, ethylene glycol diethyl ether, ethylene glycol dibutyl ether, ethylene glycol monoisopropyl ether, ethylene glycol monoethyl ether, ethylene glycol monoethyl ether acetate, ethylene glycol monotertiary butyl ether, ethylene glycol monobutyl ether, ethylene glycol monobutyl ether acetate, ethylene glycol monopropyl ether, ethylene glycol monohexyl ether, ethylene glycol monomethyl ether, ethylene glycol monomethyl ether acetate, diisobutyl ketone, diethylene glycol diethyl ether, diethylene glycol dimethyl ether, diethylene glycol monoisopropyl ether, diethylene glycol monoethyl ether acetate, diethylene glycol monobutyl ether, diethylene glycol monobutyl ether acetate, diethylene glycol monomethyl ether, cyclohexanol, cyclohexanol acetate, cyclohexanone, dipropylene glycol dimethyl ether, dipropylene glycol methyl ether acetate, dipropylene glycol monoethyl ether, dipropylene glycol monobutyl ether, dipropylene glycol monopropyl ether, dipropylene glycol monomethyl ether, diacetone alcohol, triacetin, tripropylene glycol monobutyl ether, tripropylene glycol monomethyl ether, propylene glycol diacetate, propylene glycol phenyl ether, propylene glycol monoethyl ether, propylene glycol monoethyl ether acetate, propylene glycol monobutyl ether, propylene glycol monopropyl ether, propylene glycol monomethyl ether, propylene glycol monomethyl ether acetate, propylene glycol monomethyl ether propionate, benzyl alcohol, methyl isobutyl ketone, methylcyclohexanol, n-amyl acetate, n-butyl acetate, isoamyl acetate, isobutyl acetate, propyl acetate, dibasic acid esters, an ethyl lactate.

Among these, solvents having a boiling point of 120°C or higher and 245°C or lower at 1 atm are preferred in terms of coating and drying properties.

The content of the solvent in the visible-light shielding layer composition is preferably 100 to 10,000 parts by weight, more preferably 500 to 5,000 parts by weight, relative to 100 parts by weight of the organic pigment (A).

### - Chain transfer agent

The chain transfer agent improves the photocurability of the composition. The chain transfer agent is preferably a polyfunctional thiol. Specific examples of polyfunctional thiols include hexanedithiol, decanedithiol, 1,4-butanediol bisthiopropionate, 1,4-butanediol bisthioglycolate, ethylene glycol bisthioglycolate, ethylene glycol bisthiopropionate, trimethylolpropane tristhioglycolate, trimethylolpropane tristhiopropionate, trimethylolethane tris(3-mercaptobutyrate), trimethylolpropane tris(3-mercaptobutyrate), trimethylolpropane tris(3-mercaptopropionate), pentaerythritol tetrakis thioglycolate, pentaerythritol tetrakis thiopropionate, pentaerythritol tetrakis(3-mercaptopropionate), dipentaerythritol hexakis(3-mercaptopropionate), trimercaptopropionic acid tris(2-hydroxyethyl)isocyanurate, 1,4-dimethylmercaptobenzene, 2,4,6-trimercapto-s-triazine, and 2-(N,N-dibutylamino)-4,6-dimercapto-s-triazine. When a chain transfer agent is used, the chain transfer agent is preferably contained in an amount of 0.05 to 100 parts by weight, more preferably 1 to 50 parts by weight, relative to 100 parts by weight of the organic pigment (A) from the perspective of development resistance after curing.

### - Antioxidant

An antioxidant suppresses yellowing that occurs due to oxidation of the components during the heating process. Examples of antioxidants include hindered phenol-based, hindered amine-based, phosphorus-based, sulfur-based, benzotriazole-based, benzophenone-based, hydroxylamine-based, salicylic acid ester-based, and triazine-based compounds. In order to achieve both transmittance and sensitivity of the coating film, hindered phenol-based antioxidants, hindered amine-based antioxidants, phosphorus-based antioxidants, and sulfur-based antioxidants are preferred, and hindered phenol-based antioxidants, hindered amine-based antioxidants, and phosphorus-based antioxidants are more preferred.

When an antioxidant is used, the content of the antioxidant is preferably 0.5 to 5.0 parts by weight relative to 100 parts by weight of the nonvolatile components of the visible-light shielding layer composition.

### - Leveling agent

The leveling agent improves the leveling properties of the coating film. The leveling agent is preferably dimethylsiloxane having a polyether structure or polyester structure in the main chain. Specific examples of dimethylsiloxanes having a polyether structure in the main chain include FZ-2122 manufactured by Dow Corning Toray Co., Ltd. and BYK-333 manufactured by BYK-Chemie. Specific examples of dimethylsiloxanes having a polyester structure in the main chain include BYK-310 and BYK-370 manufactured by BYK-Chemie.

Another preferred example of the leveling agent is dimethylpolysiloxane having a polyalkylene oxide unit. Examples of the polyalkylene oxide unit include a polyethylene oxide unit and a polypropylene oxide unit. Examples of dimethylpolysiloxanes having polyalkylene oxide units include FZ-2110, FZ-2122, FZ-2130, FZ-2166, FZ-2191, FZ-2203, and FZ-2207 manufactured by Dow Corning Toray Co., Ltd..

When a leveling agent is used, the content of the leveling agent is preferably 0.003 to 1.0 part by weight relative to the total weight of the nonvolatile components of the visible-light shielding layer composition.

Furthermore, an anionic, cationic, nonionic, or amphoteric surfactant may be added as an auxiliary in combination with the leveling agent.

Examples of anionic surfactants include polyoxyethylene alkyl ether sulfates, sodium dodecylbenzenesulfonate, alkali salts of styrene-acrylic acid copolymers, sodium alkylnaphthalenesulfonate, sodium alkyldiphenyletherdisulfonate, monoethanolamine lauryl sulfate, triethanolamine lauryl sulfate, ammonium lauryl sulfate, monoethanolamine stearate, sodium stearate, sodium lauryl sulfate, monoethanolamine styrene-acrylic acid copolymers, and polyoxyethylene alkyl ether phosphates.

Examples of cationic surfactants include alkyl quaternary ammonium salts and their ethylene oxide adducts.

Examples of nonionic surfactants include alcohol ethoxylates such as polyoxyethylene oleyl ether, polyoxyethylene lauryl ether, polyoxyethylene nonylphenyl ether, polyoxyethylene alkyl ether phosphates, polyoxyethylene sorbitan monostearate, and polyethylene glycol monolaurate; alkyl betaines such as alkyl dimethylaminoacetic acid betaine; and amphoteric surfactants such as alkyl imidazolines, as well as fluorine-based and silicone-based surfactants.

### - Storage stabilizer

The storage stabilizer is used to stabilize the viscosity of the visible-light shielding layer composition. Examples of storage stabilizers include quaternary ammonium chlorides such as benzyl trimethyl chloride and diethylhydroxyamine, organic acids such as lactic acid and oxalic acid and their methyl ethers, t-butylpyrocatechol, organic phosphines such as tetraethylphosphine and tetraphenylphosphine, and phosphites. The storage stabilizer can be used in an amount of 0.1 to 10 parts by weight relative to 100 parts by weight of the total amount of the organic pigment (A).

### - Adhesion promoter

The adhesion promoter is used to improve adhesion to other layers.

Examples of adhesion promoters include silane coupling agents based on vinyl silanes such as vinyltris(β-methoxyethoxy)silane, vinylethoxysilane, and vinyltrimethoxysilane; (meth)acrylic silanes such as γ-methacryloxypropyltrimethoxysilane; epoxy silanes such as β-(3,4-epoxycyclohexyl)ethyltrimethoxysilane, β-(3,4-epoxycyclohexyl)methyltrimethoxysilane, β-(3,4-epoxycyclohexyl)ethyltriethoxysilane, β-(3,4-epoxycyclohexyl)methyltriethoxysilane, γ-glycidoxypropyltrimethoxysilane, and γ-glycidoxypropyltriethoxysilane; aminosilanes such as N-β(aminoethyl)γ-aminopropyltrimethoxysilane, N-β(aminoethyl)γ-aminopropyltriethoxysilane, N-β(aminoethyl)γ-aminopropylmethyldiethoxysilane, γ-aminopropyltriethoxysilane, γ-aminopropyltrimethoxysilane, N-phenyl-γ-aminopropyltrimethoxysilane, and N-phenyl-γ-aminopropyltriethoxysilane; and thiosilanes such as γ-mercaptopropyltrimethoxysilane and γ-mercaptopropyltriethoxysilane. The adhesion promoter can be used in an amount of 0.01 to 10 parts by weight, preferably 0.05 to 5 parts by weight, relative to 100 parts by weight of the total amount of the organic pigment (A) in the visible-light shielding layer composition.

### - Ultraviolet absorber and polymerization inhibitor

The ultraviolet absorber and polymerization inhibitor improve the solubility contrast of the composition after curing.

Examples of ultraviolet absorbers include hydroxyphenyltriazine-based compounds such as 2-[4-[(2-hydroxy-3-(dodecyl and tridecyl)oxypropyl)oxy]-2-hydroxyphenyl]-4,6-bis(2,4-dimethylphenyl)-1,3,5-triazine and 2-(2-hydroxy-4-[1-octyloxycarbonylethoxy]phenyl)-4,6-bis(4-phenylphenyl)-1,3,5-triazine; benzotriazole-based compounds such as 2-(5-methyl-2-hydroxyphenyl)benzotriazole, 2-(2H-benzotriazol-2-yl)-4,6-bis(1-methyl-1-phenylethyl)phenol, and 2-(3-t-butyl-5-methyl-2-hydroxyphenyl)-5-chlorobenzotriazole; benzophenone-based compounds such as 2,4-dihydroxybenzophenone, 2-hydroxy-4-octoxybenzophenone, and 2,2',4,4'-tetrahydroxybenzophenone; salicylate-based compounds such as phenyl salicylate and p-tert-butylphenyl salicylate; and cyanoacrylate-based compounds such as ethyl-2-cyano-3,3'-diphenylacrylate; and hindered amine-based compounds such as 2,2,6,6-tetramethylpiperidine-1-oxyl (triacetoneamine-N-oxyl), bis(2,2,6,6-tetramethyl-4-piperidyl)-sebacate, and poly[[6-[(1,1,3,3-tetrabutyl)amino]-1,3,5-triazine-2,4-diyl][(2,2,6,6-tetramethyl-4-piperidinyl)imino]. Examples of polymerization inhibitors include hydroquinone derivatives and phenol compounds such as methylhydroquinone, t-butylhydroquinone, 2,5-di-t-butylhydroquinone, 4-benzoquinone, 4-methoxyphenol, 4-methoxy-1-naphthol, and t-butylcatechol;
amine compounds such as phenothiazine, bis-(1-dimethylbenzyl)phenothiazine, and 3,7-dioctylphenothiazine;
copper and manganese salt compounds such as copper dibutyldithiocarbamate, copper diethyldithiocarbamate, manganese diethyldithiocarbamate, and manganese diphenyldithiocarbamate; and
nitroso compounds such as 4-nitrosophenol, N-nitrosodiphenylamine, N-nitrosocyclohexylhydroxylamine, and N-nitrosophenylhydroxylamine, and their ammonium or aluminum salts.

When an ultraviolet absorber and/or a polymerization inhibitor is used, their total content is preferably 0.01 to 20 parts by weight, more preferably 0.05 to 10 parts by weight, relative to 100 parts by weight of the organic pigment (A).

Each of the components in the visible-light shielding layer composition may independently be of a single type, or a combination of two or more types.

### (2) Near-Infrared Light Shielding Layer Composition

The near-infrared light shielding layer composition contains a near-infrared-light-absorbing dye (E) represented by the following general formula (1), a resin-type dispersant having an amine value of 20 mg KOH/g to 200 mg KOH/g (F) (hereinafter simply referred to as the resin-type dispersant (F)), and a binder resin having a weight-average molecular weight of 5,000 to 40,000 and an acid value of 100 mg KOH/g to 130 mg KOH/g (G) (hereinafter simply referred to as the binder resin (G)). Such a composition satisfies the above-mentioned spectral characteristics and film-forming conditions.

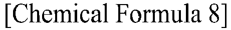

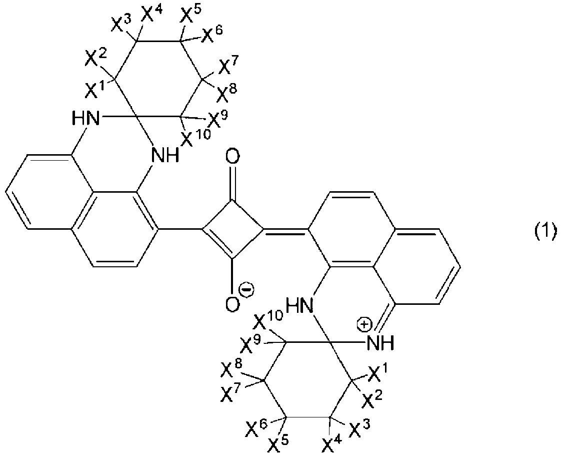

X¹ to X¹⁰ each independently represent a hydrogen atom, an alkyl group which may have one or more substituents, an alkenyl group which may have one or more substituents, an aryl group which may have one or more substituents, an aralkyl group which may have one or more substituents, an alkoxy group which may have one or more substituents, an aryloxy group which may have one or more substituents, an amino group, a substituted amino group, a sulfo group, - SO₂NR¹R², -COOR¹, -CONR¹R², a nitro group, a cyano group, or a halogen atom, and X¹ to X¹⁰ may be bonded to each other to form a ring.

R¹ and R² each independently represent a hydrogen atom or an alkyl group which may have one or more substituents.

### (Near-Infrared-Light-Absorbing Dye (E))

The near-infrared-light-absorbing dye represented by the general formula (1) has little absorption of visible light (wavelengths of 400 to 700 nm), and has good near-infrared-light-absorbing ability and durability.

Examples of the alkyl group for X¹ to X¹⁰ which may have one or more substituents include a methyl group, an ethyl group, an n-propyl group, an isopropyl group, a tert-butyl group, a tert-amyl group, a 2-ethylhexyl group, a stearyl group, a chloromethyl group, a trichloromethyl group, a trifluoromethyl group, a 2-methoxyethyl group, a 2-chloroethyl group, a 2-nitroethyl group, a cyclopentyl group, a cyclohexyl group, and a dimethylcyclohexyl group. Among these, in terms of durability of the compound and ease of synthesis, a methyl group, an ethyl group, and an n-propyl group are preferred, and a methyl group is more preferred.

Examples of the alkenyl group for X¹ to X¹⁰ which may have one or more substituents include a vinyl group, a 1-propenyl group, an allyl group, a 2-butenyl group, a 3-butenyl group, an isopropenyl group, an isobutenyl group, a 1-pentenyl group, a 2-pentenyl group, a 3-pentenyl group, a 4-pentenyl group, a 1-hexenyl group, a 2-hexenyl group, a 3-hexenyl group, a 4-hexenyl group, and a 5-hexenyl group. Among these, a vinyl group and an allyl group are preferred in terms of the durability of the compound and ease of synthesis.

Examples of the aryl group for X¹ to X¹⁰ which may have one or more substituents include a phenyl group, a naphthyl group, a 4-methylphenyl group, a 3,5-dimethylphenyl group, a pentafluorophenyl group, a 4-bromophenyl group, a 2-methoxyphenyl group, a 4-diethylaminophenyl group, a 3-nitrophenyl group, and a 4-cyanophenyl group. Among these, a phenyl group and a 4-methylphenyl group are preferred in terms of the durability of the compound and ease of synthesis.

Examples of the aralkyl group for X¹ to X¹⁰ which may have one or more substituents include a benzyl group, a phenethyl group, a phenylpropyl group, and a naphthylmethyl group. Among these, a benzyl group is preferred in terms of the durability of the compound and ease of synthesis.

Examples of the alkoxy group for X¹ to X¹⁰ which may have one or more substituents include a methoxy group, an ethoxy group, an n-propoxy group, an isopropoxy group, an n-butoxy group, an n-octyloxy group, a 2-ethylhexyloxy group, a trifluoromethoxy group, a cyclohexyloxy group, and a stearyloxy group. Among these, a methoxy group, an ethoxy group, and a trifluoromethoxy group are preferred in terms of the durability of the compound and ease of synthesis.

Examples of the aryloxy group for X¹ to X¹⁰ which may have one or more substituents include a phenoxy group, a naphthyloxy group, a 4-methylphenyloxy group, a 3,5-chlorophenyloxy group, a 4-chloro-2-methylphenyloxy group, a 4-tert-butylphenyloxy group, a 4-methoxyphenyloxy group, a 4-diethylaminophenyloxy group, and a 4-nitrophenyloxy group. Among these, a phenoxy group and a naphthyloxy group are preferred in terms of the durability of the compound and ease of synthesis.

Examples of the substituted amino group for X¹ to X¹⁰ include a methylamino group, an ethylamino group, an isopropylamino group, an n-butylamino group, a cyclohexylamino group, a stearylamino group, a dimethylamino group, a diethylamino group, a dibutylamino group, an N,N-di(2-hydroxyethyl)amino group, a phenylamino group, a naphthylamino group, a 4-tert-butylphenylamino group, a diphenylamino group, and an N-phenyl-N-ethylamino group. Among these, a dimethylamino group and a diethylamino group are preferred in terms of the durability of the compound and ease of synthesis.

Examples of the halogen atom for X¹ to X¹⁰ include fluorine, bromine, chlorine and iodine.

Examples of the structure in which X¹ to X¹⁰ are bonded to each other to form a ring include the following structures. Here, * represents a bonding site.

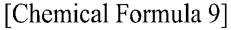

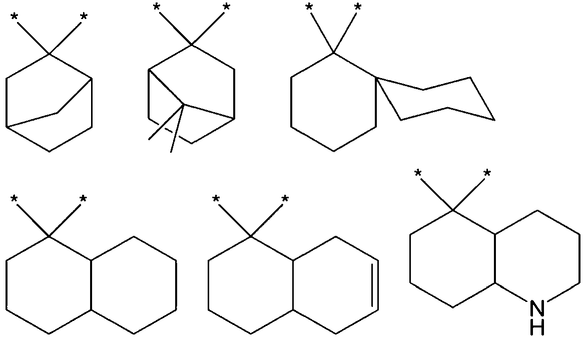

The alkyls which may have one or more substituents for R¹ and R² are the same as those for X¹ to X¹⁰, including their preferred modes.

In particular, it is preferable that X¹ to X¹⁰ include an unsubstituted alkyl group. It is more preferable that at least one of X³, X⁴, X⁷, and X⁸ is an unsubstituted alkyl group, and it is further preferable that X³ and X⁷ are unsubstituted alkyl groups. Furthermore, the unsubstituted alkyl group is particularly preferably a methyl group.

The content of the near-infrared-light-absorbing dye (E) in the near-infrared light shielding layer composition is preferably from 0.01 to 50% by weight, and more preferably from 0.1 to 30% by weight, relative to the non-volatile components in the near-infrared light shielding layer composition, from the perspective of the near-infrared light absorption ability of the cured product.

The near-infrared-light-absorbing dye (E) is preferably used in a micronized form. The primary particle size of the near-infrared-light-absorbing dye (E) is preferably 1 to 200 nm, more preferably 10 to 150 nm, and even more preferably 10 to 100 nm. When the average primary particle size is 1 nm or more, aggregation of the near-infrared-light-absorbing dye (E) is suppressed, and the dispersibility and dispersion stability are improved. On the other hand, when the primary particle size is 200 nm or less, the influence of particle scattering is reduced and a sharper absorption spectrum can be obtained. The particle size is measured in the same manner as in the case of the organic pigment (A).

The near-infrared-light-absorbing dye (E) may be a commercially available product or may be synthesized. The synthesis method is not particularly limited, but as an example, synthesis can be carried out based on the following scheme 1. Specifically, 1,8-diaminonaphthalene (the following formula (2)) and the compound represented by the following formula (3) are heated and refluxed together with a catalyst in a solvent to synthesize a compound of the following formula (4), and 3,4-dihydroxy-3-cyclobutene-1,2-dione is added and the mixture is further heated and refluxed to obtain the compound represented by formula (1) (near-infrared-light-absorbing dye (E)).

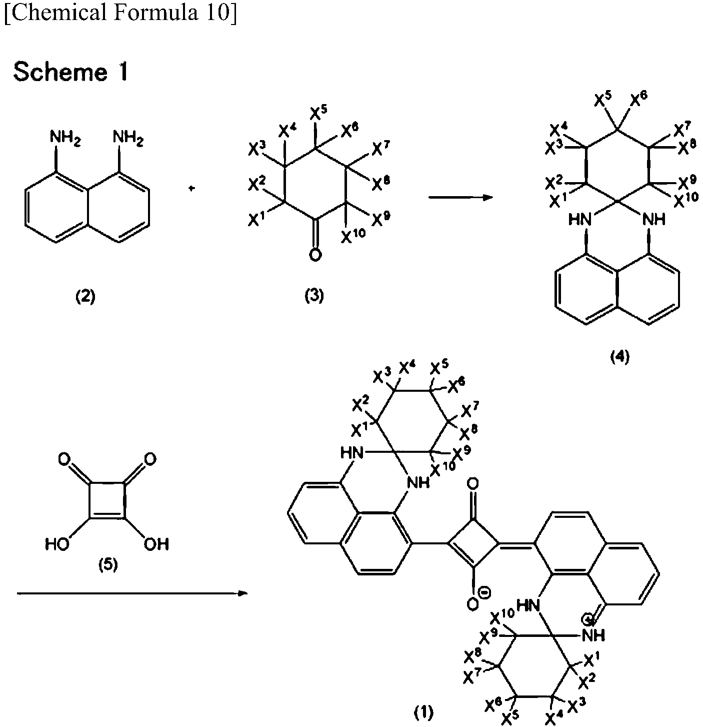

### (Resin-Type Dispersant (F))

The near-infrared light shielding layer composition contains a resin-type dispersant (F) having an amine value of 20 mgKOH/g to 200 mgKOH/g from the perspectives of dispersibility and dispersion stability of the near-infrared-light-absorbing dye (E). The amine value is preferably 60 to 150 mgKOH/g, and more preferably 60 to 120 mgKOH/g.

The resin-type dispersant (F) has a site with affinity for the dye (E) and a site that is compatible with a carrier such as the binder resin (G), and adsorbs to the dye (E) to stabilize the dispersion. In particular, resins with controlled structures such as the graft type (comb-shaped) and block type are preferred. Specific examples of the main chain and/or side chain skeleton of the resin-type dispersant include polyurethane, polycarboxylic acid esters such as polyacrylate, unsaturated polyamides, polycarboxylic acids, polycarboxylic acid (partial) amine salts, polycarboxylic acid ammonium salts, polycarboxylic acid alkylamine salts, polysiloxanes, long-chain polyaminoamidophosphate salts, hydroxyl group-containing polycarboxylic acid esters, and modified products thereof, oil-based dispersants such as amides formed by reacting poly(lower alkylene imine) with polyesters having free carboxyl groups and their salts, water-soluble resins and water-soluble polymer compounds such as (meth)acrylic acid-styrene copolymers, (meth)acrylic acid-(meth)acrylic acid ester copolymers, styrene-maleic acid copolymers, polyvinyl alcohol, and polyvinylpyrrolidone, polyesters, modified polyacrylates, ethylene oxide/propylene oxide adducts, and phosphate esters. Among these, those having a (meth)acrylic copolymer as the main chain and/or side chain are preferred. Specific examples of the dye-adsorbing group of the resin-type dispersant (F) include acidic adsorbing groups such as aromatic carboxyl groups and phosphate groups, and basic adsorbing groups such as primary amino groups, secondary amino groups, tertiary amino groups, and quaternary ammonium salts. Among these, resin-type dispersants having an aromatic carboxyl group, a tertiary amino group, or a quaternary ammonium salt as the dye-adsorbing group are preferred from the perspectives of near-infrared absorption ability and durability, and among these, resin-type dispersants having a tertiary amino group or a quaternary ammonium salt are more preferred, and resin-type dispersants having a tertiary amino group and a quaternary ammonium salt are even more preferred. When the resin-type dispersant contains both a tertiary amino and a quaternary ammonium salt, it is preferable from the perspectives of not only transmittance in the visible region, near-infrared absorption ability, durability, and patterning properties, but also storage stability.

Examples of the resin-type dispersant (F) include Disperbyk-106, 108, 109, 112, 116, 130, 140, 142, 145, 166, 180, 187, 2001, 2010, 2020, 2025, 2050, 2070, and 6919 manufactured by BYK Japan, SOLSPERSE-13240, 13650, 13940, 20000, 24000, 26000, 32000, 33000, 39000, 56000, and 71000 manufactured by Lubrizol Japan Ltd., and AJISPER PB711 manufactured by Ajinomoto Fine-Techno Co., Inc.

The resin-type dispersant (F) can be produced by a known method such as the method described in JP 2010-506016 A. When the resin-type dispersant (F) is a block copolymer, it may be produced by copolymerizing, for example, a monomer having a tertiary amino group or a quaternary amino group with another monomer. When the resin-type dispersant (F) is a graft copolymer, it can be produced by grafting a monomer having a tertiary amino group or a quaternary amino group onto a reactive group in the side chain of the polymer that forms the main chain.

The content of the resin-type dispersant (F) in the near-infrared light shielding layer composition is preferably 5 to 200% by weight, more preferably 10 to 150% by weight, relative to the weight of the near-infrared-light-absorbing dye (E), from the perspectives of optical properties and durability.

### (Binder Resin (G))

The near-infrared light shielding layer composition contains a binder resin (G) having a weight-average molecular weight of 5,000 to 40,000 and an acid value of 100 mgKOH/g to 130 mgKOH/g, from the perspectives of storage stability, alkali developability, and the like. The binder resin (G) preferably has a spectral transmittance of 80% or more, more preferably 95% or more, in the entire wavelength range of the visible light region (wavelengths of 400 to 700 nm). Among these, an acrylic copolymer containing methacrylic acid and hydroxyethyl methacrylate as monomers is preferred from the perspective of storage stability of the composition.

In order to further improve photosensitivity and solvent resistance, the weight-average molecular weight of the binder resin (G) is more preferably 10,000 to 30,000. The acid value is more preferably 100 mgKOH/g to 120 mgKOH/g. The binder resin (G) may be an active energy ray-curable resin having an ethylenically unsaturated double bond, and in particular, an alkali-soluble active energy ray-curable resin is preferred.

Specific examples of the active energy ray-curable resin having an ethylenically unsaturated double bond and the alkali-soluble active energy ray-curable resin are the same as those described above for the binder resin (B), and therefore description thereof will be omitted.

The number-average molecular weight (Mn) of the binder resin (G) is preferably in the range of 25,000 to50,000, and the value of Mw/Mn is preferably 10 or less, from the perspective of dispersibility of the near-infrared-light-absorbing dye (E).

The proportion of the binder resin (G) in the near-infrared light shielding layer composition is preferably 30 to 500 parts by weight relative to 100 parts by weight of the near-infrared-light-absorbing dye (E) from the perspectives of film-forming properties and durability of the cured film.

### (Optional Components)

The near-infrared light shielding layer composition may further contain other components. Examples of the other components include photopolymerizable monomers, photolinitiators, solvents, sensitizers, chain transfer agents, antioxidants, amine compounds, leveling agents, curing agents, curing accelerators, other near-infrared-light-absorbing dyes, storage stabilizers, and adhesion promoters.

### - Photopolymerizable monomer

The photopolymerizable monomer may be any of those listed above for the photopolymerizable compound (D), and preferably includes a polyfunctional monomer.

When a photopolymerizable monomer is used, the proportion of the photopolymerizable monomer is preferably 5 to 400 parts by weight, more preferably 10 to 300 parts by weight, relative to 100 parts by weight of the near-infrared-light-absorbing dye (E) from the perspective of curability and developability.

### - Photoinitiator

Examples of the photoinitiator include the same ones as those listed for the photoinitiator (C) above. Among them, oxime ester compounds and amino ketone compounds are preferred from the perspectives of sensitivity and resolution.

When a photoinitiator is used, the proportion of the photoinitiator is preferably 5 to 200 parts by weight, more preferably 10 to 150 parts by weight, relative to 100 parts by weight of the near-infrared-light-absorbing dye (E) from the perspectives of curability and developability.

### - Solvent

The solvent may be the same as those exemplified for the visible-light shielding layer composition. The content of the solvent in the near-infrared light shielding layer composition is preferably 500 to 4,000 parts by weight relative to 100 parts by weight of the near-infrared-light-absorbing dye (E).

### - Sensitizer

The sensitizer may be the same as those exemplified for the visible-light shielding layer composition. When a sensitizer is used, it is preferably contained in an amount of 3 to 60 parts by weight, more preferably 5 to 50 parts by weight, relative to 100 parts by weight of the photoinitiator from the perspectives of curability and developability.

### - Chain transfer agent

The chain transfer agent may be the same as those exemplified for the visible-light shielding layer composition. When a chain transfer agent is used, the chain transfer agent is preferably contained in an amount of 0.1 to 30 parts by weight, more preferably 1 to 20 parts by weight, relative to 100 parts by weight of the total amount of the nonvolatile components of the near-infrared light shielding layer composition, from the perspective of development resistance after curing.

### - Antioxidant

The antioxidant may be the same as those exemplified for the visible-light shielding layer composition. When an antioxidant is used, the content of the antioxidant is preferably 0.5 to 5.0 parts by weight relative to 100 parts by weight of the nonvolatile components of the near-infrared light shielding layer composition.

### - Amine compound

The amine compound is used to reduce oxygen dissolved in the near-infrared light shielding layer composition. Examples of such amine compounds include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, and N,N-dimethyl-p-toluidine.

### - Leveling agent

The leveling agent may be the same as those exemplified for the visible-light shielding layer composition. When a leveling agent is used, the content of the leveling agent is preferably 0.003 to 1.0 part by weight relative to the total weight of the nonvolatile components of the near-infrared light shielding layer composition.

### - Storage stabilizer

The storage stabilizer may be the same as those exemplified for the visible-light shielding layer composition. The storage stabilizer can be used in an amount of 0.1 to 10 parts by weight relative to 100 parts by weight of the total amount of the near-infrared-light-absorbing dye (E).

### - Adhesion promoter

The adhesion promoter may be the same as those exemplified for the visible-light shielding layer composition. The adhesion promoter can be used in an amount of 0.01 to 10 parts by weight, more preferably 0.05 to 5 parts by weight, relative to 100 parts by weight of the total amount of the near-infrared-light-absorbing dye (E).

### - Other near-infrared-light-absorbing dyes

The near-infrared light shielding layer composition may contain near-infrared-light-absorbing dyes other than the near-infrared-light-absorbing dye (E). Examples of the near-infrared-light-absorbing dyes include cyanine compounds, squarylium compounds, phthalocyanine compounds, naphthalocyanine compounds, aminium compounds, diimmonium compounds, croconium compounds, azo compounds, quinoid complex compounds, and dithiol metal complex compounds.

Each of the components in the near-infrared light shielding layer composition may independently be of a single type, or a combination of two or more types.

### (3) Colored Layer Composition

The colored layer composition contains at least a colorant (H), a photopolymerizable compound (I), and a photoinitiator (J), and may contain other components if necessary.

### (Colorant (H))

The colorant (H) is used so that each colored layer has desired spectral characteristics, and can be appropriately selected from known pigments and dyes.

Either an organic pigment or an inorganic pigment can be suitably used as the pigment. Furthermore, the color layer composition described below has good low-temperature curing properties, and therefore can be suitably used with dyes, which have lower heat resistance than pigments.

Examples of inorganic pigments include metal oxide powders of barium sulfate, zinc white, lead sulfate, yellow lead, zinc yellow, red iron oxide (red iron (III) oxide), cadmium red, ultramarine, Prussian blue, chromium oxide green, cobalt green, umber, titanium black, synthetic iron black, titanium oxide, and iron tetroxide, as well as metal sulfide powders and metal powders. Inorganic pigments are preferably used in combination with organic pigments in order to ensure good coating properties, sensitivity, developability, and the like while maintaining a good balance between saturation and brightness.

Examples of dyes include acid dyes, direct dyes, basic dyes, salt-forming dyes, oil-soluble dyes, disperse dyes, reactive dyes, mordant dyes, vat dyes, and sulfur dyes. Furthermore, dyes may also be in the form of derivatives of these examples or lake pigments obtained by converting these dyes to lakes.

The colorant (H) preferably contains a pigment, and more preferably an organic pigment, from the perspectives of high color development and good heat resistance, particularly good resistance to thermal decomposition.

Next, the colorant (H) will be described in more detail for each color. Note that one or more colorants (H) may be used for each color.

### - Red layer

The colorant for the red layer preferably contains a red pigment, and may further contain an orange pigment, a yellow pigment, or the like.

Specific examples of red pigments include C. I. Pigment Red (PR) 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57 , 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232 , 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276.

Specific examples of orange pigments include C. I. Pigment Orange 36, 38, 43, 51, 55, 59, and 61. Specific examples of yellow pigments include the same pigments as those exemplified for the organic pigment (A).

The colorant for the red layer preferably contains Pigment Red 177, and more preferably contains Pigment Red 139, Pigment Red 177, and Pigment Red 254, from the perspectives of high brightness and color reproducibility. When PY139, PY177, and PY254 are used in combination, it is preferable that the content of PY177 be 55 to 65% by weight, the content of PY254 be 15 to 25% by weight, and the content of PY139 be 15 to 25% by weight, in the red colorant.

### - Green layer

The colorant for the green layer preferably contains a green or blue pigment, and may further contain a yellow pigment or the like.

Specific examples of the green pigments include C. I. Pigment Green (PG) 1, 2, 4, 7, 8, 10, 13, 14, 15, 17, 18, 19, 26, 36, 45, 48, 50, 51, 54, 55, 58, 59, 62, and 63.

Specific examples of blue and yellow pigments include the same pigments as those exemplified for the organic pigment (A).

From the perspectives of high brightness and color reproducibility, the colorant for the green layer preferably contains Pigment Yellow 185, and more preferably contains any one of Pigment Green 36, Pigment Green 58, and Pigment Blue 15:3.

The content of PY185 in the colorant for the green layer is preferably 49 to 59% by weight. The total content of PG36 and PG58 in the colorant for the green layer is preferably 33 to 43% by weight. The content of PB15:3 in the colorant for the green filter is preferably 3 to 13% by weight.

### - Blue layer

The colorant for the blue layer preferably contains a blue pigment, and may further contain a violet pigment, a xanthene dye, or the like.

Specific examples of blue and violet pigments include the same pigments as those exemplified for the organic pigment (A).

The xanthene dye may be any of an oil-soluble dye, an acid dye, a direct dye, and a basic dye, and may be used as a lake pigment.

Specific examples of oil-soluble xanthene dyes include C. I. Solvent Red 35, C. I. Solvent Red 36, C. I. Solvent Red 42, C. I. Solvent Red 43, C. I. Solvent Red 44, C. I. Solvent Red 45, C. I. Solvent Red 46, C. I. Solvent Red 47, C. I. Solvent Red 48, C. I. Solvent Red 49, C. I. Solvent Red 72, C. I. Solvent Red 73, C. I. Solvent Red 109, C. I. Solvent Red 140, C. I. Solvent Red 141, C. I. Solvent Red 237, C. I. Solvent Red 246, C. I. Solvent Violet 2, and C. I. Solvent Violet 10. From the perspective of color development, C. I. Solvent Red 35, C. I. Solvent Red 36, C. I. Solvent Red 49, C. I. Solvent Red 109, C. I. Solvent Red 237, C. I. Solvent Red 246, and C. I. Solvent Violet 2 are preferred.

Specific examples of basic xanthene dyes include C. I. Basic Red 1 (Rhodamine 6GCP) and 8 (Rhodamine G) and C. I. Basic Violet 10 (Rhodamine B). Because of their good color development properties, C. I. Basic Red 1 and C. I. Basic Violet 10 are preferred.

Specific examples of acidic xanthene dyes include C. I. Acid Red 51 (Erythrosine (Food Red 3)), C. I. Acid Red 52 (Acid Rhodamine), C. I. Acid Red 87 (Eosin G (Food Red 103)), C. I. Acid Red 92 (Acid Phloxine PB (Food Red 104)), C. I. Acid Red 289, C. I. Acid Red 388, Rose Bengal B (Food Red 5), Acid Rhodamine G, and C. I. Acid Violet 9. From the perspectives of heat resistance and light resistance, C. I. Acid Red 87, C. I. Acid Red 92, C. I. Acid Red 388, C. I. Acid Red 52 (Acid Rhodamine), C. I. Acid Red 289, Acid Rhodamine G, and C. I. Acid Violet 9 are more preferred, and C. I. Acid Red 52 and C. I. Acid Red 289 are even more preferred.

The colorant for the blue layer preferably contains Pigment Blue 15:6, and more preferably contains Pigment Violet 23 or a xanthene dye.

The content of PB15:6 in the colorant for the blue layer is preferably 58 to 64% by weight. The content of PV23 in the colorant for the blue layer is preferably 12 to 20% by weight. The content of a xanthene dye in the colorant for the blue layer is preferably 17 to 25% by weight.

For all of the colorants of different colors described above, when a pigment is used, it is preferably used in a micronized form. The method for finely dividing a pigment and the preferred particle size are the same as those for the organic pigment (A).

### (Photopolymerizable Compound (I))

Examples of the photopolymerizable compound (I) include the same compounds as those described for the photopolymerizable compound (D). The photopolymerizable compound (I) preferably contains a compound represented by the above general formula (7) in order to achieve both good adhesion to other layers and high resolution of the resist pattern.

The content of the photopolymerizable compound (I) in the total nonvolatile content of the color layer composition is preferably 5 to 40% by weight. When its content is within this range, it is possible to obtain good adhesion of the fine pattern and suppress taper spread, enabling the production of a high-resolution display device. Furthermore, the content of the compound represented by the general formula (1) contained in the photopolymerizable compound (I) is preferably 50 to 100% by weight, more preferably 60% by weight or more, relative to the total mass of the photopolymerizable compound (I). When its content is within this range, it is possible to improve the adhesion of the coating film to the substrate during the manufacturing process and its chemical resistance.

### (Photoinitiator (J))

The photoinitiator (J) can be appropriately selected from those that promote the polymerization reaction of the photopolymerizable compound under the action of light.

In the present disclosure, it is preferable that an oxime ester-based photoinitiator is contained, as this has good ultraviolet curability, color properties, chemical resistance, and developability.

The content of the photoinitiator (J) is preferably 0.5 to 50 parts by weight, and more preferably 1 to 30 parts by weight, relative to 100 parts by weight of the colorant (H), from the perspectives of photocurability and developability. When the content of the photoinitiator (J) is 1 part by weight or more, good adhesion to the substrate can be obtained. Furthermore, when the content of the photoinitiator (J) is 30 parts by weight or less, high resolution can be achieved.

### - Optional components

The colored layer composition may further contain other components. Examples of the other components include sensitizers, resins, thermosetting compounds, antioxidants, adhesion promoters, leveling agents, curing agents, curing accelerators, storage stabilizers, solvents, dispersing aids, and chain transfer agents.

### - Sensitizer

Examples of the sensitizer include those exemplified for the visible-light shielding layer composition.

Particularly suitable sensitizers include thioxanthone derivatives, Michler's ketone derivatives, and carbazole derivatives. When a sensitizer is used, the content of the sensitizer is preferably 3 to 60 parts by weight, more preferably 5 to 50 parts by weight, relative to 100 parts by weight of the photoinitiator (J), from the perspectives of photocurability and developability.

### - Resin

The colored layer composition may further contain a resin. The resin is preferably a transparent resin that, when formed into a coating having a thickness of 2 µm, has a transmittance of 80% or more in the entire wavelength range of 400 to 700 nm, and the transmittance is preferably 95% or more. Examples of the resin include active energy ray curable resins and thermoplastic resins. From the perspective of patterning properties by photolithography, the resin preferably contains an alkali-soluble resin. Examples of the resin include those exemplified for the binder resin (B).

The content of the resin is preferably 20 to 400 parts by weight, more preferably 50 to 250 parts by weight, relative to 100 parts by weight of the colorant (H). When the resin is contained in an appropriate amount, a coating can be easily formed and good color characteristics can be easily obtained.

### - Antioxidant

The colored layer composition may further contain an antioxidant. Examples of the antioxidant include those mentioned above. When an antioxidant is used, the antioxidant is preferably contained in an amount of 0.5 to 5.0% by weight relative to the total nonvolatile content of the colored layer composition from the perspectives of brightness and sensitivity.

### - Adhesion promoter

The colored layer composition may further contain an adhesion promoter. Examples of the adhesion promoter include those mentioned above. The adhesion promoter can be used in an amount of 0.01 to 10 parts by weight, preferably 0.05 to 5 parts by weight, relative to 100 parts by weight of the colorant in the colored layer composition.

### - Leveling agent

The colored layer composition may further contain a leveling agent. Examples of the leveling agent include those mentioned above. The leveling agent is preferably used in an amount of 0.003 to 0.5% by weight based on the total nonvolatile content of the colored layer composition.

### - Solvent

The colored layer composition may contain a solvent. This facilitates adjusting the viscosity of the colored layer composition, which in turn facilitates the formation of a coating film with a smooth surface. The solvent may be the same as those exemplified for the visible-light shielding layer composition.

In order to adjust the viscosity of the colored layer composition to an appropriate level and form a coating film with the desired uniform thickness, the solvent is preferably used in an amount of 200 to 900 parts by weight, more preferably 300 to 570 parts by weight, relative to 100 parts by weight of the nonvolatile content of the colored layer composition. The viscosity of the colored layer composition is preferably 2.4 to 7.2 mPa·s, and more preferably 3.4 to 6.4 mPa·s.

### - Dispersing aid

The colored layer composition may contain a dispersing aid such as a dye derivative, a resin-type dispersant, or a surfactant, as appropriate, in order to disperse the colorant in the solvent. Since a dispersing aid significantly prevents the re-aggregation of colorants after dispersion, a colored layer composition obtained by dispersing a colorant in the colorant carrier using a dispersing aid can have good brightness and viscosity stability.

### ((Dye Derivative))

Examples of the dye derivative include compounds in which a basic substituent, an acidic substituent, or a phthalimidomethyl group which may have one or more substituents has been introduced into an organic pigment, an anthraquinone, an acridone, or a triazine. For example, the compounds described in JP 1987-305173 A, JP 1982-15620 A, JP 1984-40172 A, JP 1987-17102 A, JP 1993-9469 A, JP 2001-335717 A, JP 2003-128669 A, JP 2004-091497 A, JP 2007-156395 A, JP 2008-094873 A, JP 2008-094986 A, JP 2008-095007 A, JP 2008-195916 A, and JP 4585781 B can be used. These can be used singly or in combination of two or more.

From the perspective of improving dispersibility, the content of the dye derivative is preferably 0.5 parts by weight or more, more preferably 1 part by weight or more, and most preferably 3 parts by weight or more, relative to 100 parts by weight of the colorant. From the perspectives of heat resistance and light resistance, its content is preferably 40 parts by weight or less, and more preferably 35 parts by weight or less.

### ((Resin-Type Dispersant/Surfactant))

Examples of resin-type dispersants include those exemplified for the resin-type dispersant (F) above. Examples of surfactant include those exemplified for the visible-light shielding layer composition above. When a resin-type dispersant or surfactant is added, its content is preferably 0.1 to 55 parts by weight, more preferably 0.1 to 45 parts by weight, relative to 100 parts by weight of the colorant.

### - Chain transfer agent

The colored layer composition may contain a chain transfer agent. The chain transfer agent is as described above. The content of the chain transfer agent is preferably 0.5 to 10%, more preferably 1 to 8%, of the total nonvolatile content of the color layer composition.

### - Near-infrared-light-absorbing dye

When the colored layer is the colored layer 7 having near-infrared-light-shielding properties shown in Fig. 4, the colored layer composition contains a near-infrared-light-absorbing dye. The near-infrared-light-absorbing dye is preferably the near-infrared-light-absorbing dye (E) represented by the general formula (1).

### [Substrate]

The substrate 10 is a substrate on which electrodes for driving the organic EL layer, the near-infrared light receiving and emitting portions, and electrodes for inputting electrical signals from the near-infrared light receiving portion are formed, and is preferably a silicon substrate. For example, the electrodes are formed in the form of a TFT array.

### [Organic EL Layer]

The organic EL layer 30 is a multilayer structure in which a lower electrode, a light emitting layer, and a transparent electrode are laminated, and may further include other layers. An example of the organic EL layer is a structure in which a lower electrode, an organic layer including a light emitting layer, and a transparent electrode are laminated in this order from the substrate 10 side, and are airtightly covered with a sealing layer.

One of the lower electrode and the transparent electrode is an anode and the other is a cathode, and either may be the anode.

Examples of the material of the anode include nickel, silver, gold, platinum, palladium, selenium, rhodium, ruthenium, iridium, rhenium, tungsten, molybdenum, chromium, tantalum, niobium, and alloys thereof, as well as tin oxide (SnO₂), indium tin oxide (ITO), zinc oxide, and titanium oxide.

Examples of the material of the cathode include alloys of an active metal such as Li, Mg, or Ca with a metal such as Ag, Al, or In, or the cathode may have a laminated structure of these metals. Alternatively, a thin compound layer of an active metal such as Li, Mg, or Ca and a halogen such as fluorine or bromine, or oxygen may be inserted between the organic layer and the cathode.

The organic layer has at least a white light emitting layer. However, it typically includes a plurality of organic layers, and may include a charge injection layer such as a hole injection layer or an electron injection layer, a hole transport layer that transports holes to the white light emitting layer, and a charge transport layer such as an electron transport layer that transports electrons to the white light emitting layer. The organic layer can have any of a variety of known structures including a white light emitting layer.

The light emitting layer may be any known layer that emits white light. The white light emission characteristics are sufficient if there is emission in at least three regions, namely, the red region (600 to 780 nm), the green region (475 to 600 nm), and the blue region (380 to 475 nm). The number of emission peaks does not necessarily need to be three or more. For example, two emission peaks may be sufficient as long as there is emission in the above-mentioned regions. However, in order to obtain a wide color reproducibility, it is preferable to use a white light emitting layer having three or more emission peaks, and it is preferable that the emission peaks be in one or more of the above three color regions.

The material for forming such a white light emitting layer is not particularly limited as long as it emits fluorescence or phosphorescence. The light-emitting material may also have hole transporting properties or electron transporting properties. Examples of the light-emitting material include dye-based materials, metal complex-based materials, and polymeric materials.

Examples of the dye-based materials include cyclopentamine derivatives, tetraphenylbutadiene derivatives, triphenylamine derivatives, oxadiazole derivatives, pyrazoloquinoline derivatives, distyrylbenzene derivatives, distyrylarylene derivatives, silole derivatives, thiophene ring compounds, pyridine ring compounds, perinone derivatives, perylene derivatives, oligothiophene derivatives, triphimanylamine derivatives, oxadiazole dimers, and pyrazoline dimers.

Examples of the metal complex-based materials include aluminum quinolinol complexes, benzoquinolinol beryllium complexes, benzoxazole zinc complexes, benzothiazole zinc complexes, azomethyl zinc complexes, porphyrin zinc complexes, and europium complexes, as well as metal complexes having Al, Zn, Be, or the like or a rare earth metal such as Tb, Eu, or Dy as the central metal and having an oxadiazole, thiadiazole, phenylpyridine, phenylbenzimidazole, or quinoline structure as a ligand.

Examples of the polymeric materials include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized forms of the above-mentioned dye-based materials and metal complex-based materials.

Examples of methods for forming the white light emitting layer include vapor deposition, printing, inkjet printing, spin coating, casting, dipping, bar coating, blade coating, roll coating, gravure coating, flexographic printing, spray coating, and self-assembly methods (layer-by-layer adsorption and self-assembled monolayer formation). In particular, it is preferable to use vapor deposition, spin coating, or inkjet printing. The thickness of the white light emitting layer is typically about 5 nm to 5 µm.

The organic EL layer may also include a hole injection layer between the white light emitting layer and the anode. The hole injection layer stabilizes the injection of holes into the white light emitting layer and improves luminous efficiency. The material for forming the hole injection layer may be any of the materials generally used for hole injection layers of organic EL elements. The material for forming the hole injection layer may be any material that has either hole injection properties or electron barrier properties.

Specific examples of materials for forming the hole injection layer include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, polysilane-based copolymers, aniline-based copolymers, and conductive polymer oligomers such as thiophene oligomers.

Further examples of materials for forming the hole injection layer include porphyrin compounds, aromatic tertiary amine compounds, and styrylamine compounds. The thickness of the hole injection layer is typically about 5 nm to 1 µm.

The organic EL layer may also include an electron injection layer between the white light emitting layer and the cathode. The electron injection layer stabilizes the injection of electrons into the white light emitting layer and improves luminous efficiency.

Examples of materials for forming the electron injection layer include nitro-substituted fluorene derivatives, anthraquinodimethane derivatives, diphenylquinone derivatives, thiopyran dioxide derivatives, heterocyclic tetracarboxylic acid anhydrides such as naphthalene perylene, carbodiimides, fluorenylidenemethane derivatives, anthraquinodimethane and anthrone derivatives, oxadiazole derivatives, thiazole derivatives in which the oxygen atom of the oxadiazole ring of an oxadiazole derivative is substituted with a sulfur atom, quinoxaline derivatives having a quinoxaline ring known as an electron-withdrawing group, metal complexes of 8-quinolinol derivatives such as tris(8-quinolinol)aluminum, phthalocyanines, metal phthalocyanines, and distyrylpyrazine derivatives.

### 2. Method for Manufacturing Organic EL Display Device

A method for manufacturing an organic EL display device according to the present disclosure is a method for manufacturing the organic EL display devices according to the first and second embodiments, characterized in that the colored layer, the visible-light shielding layer, and the near-infrared light shielding layer are all formed at 120°C or lower. According to this manufacturing method, even when a color filter is formed directly on an organic EL element, thermal damage to the organic EL element can be suppressed, and a step of bonding the organic EL element and the color filter together is not required, thereby suppressing the occurrence of misalignment.

In a specific example of the method for manufacturing an organic EL display device, first, a laminated substrate is prepared that includes a substrate and a near-infrared light receiving portion, a lower electrode, a light emitting layer, and a transparent electrode provided on the substrate. The method for preparing the laminated substrate is not particularly limited, and it can be manufactured by a known process. A sealing layer and/or an adhesion layer may be formed on the transparent electrode. The sealing layer can be made of a known curable resin, preferably an active energy ray-curable resin, optionally in combination with a thermosetting resin. The active energy ray-curable resin is not particularly limited, but is preferably an acrylic resin that is sensitive to i-line (wavelength 365 nm). By forming the sealing layer, the surface on which the color filter is to be formed can be flattened.

The color filter is formed directly on the transparent electrode, the sealing layer, or the adhesion layer. The color filter is preferably formed by photolithography. In the case of photolithography, the above-mentioned visible-light shielding layer composition, near-infrared light shielding layer composition, and compositions for the red, green, and blue colored layers are prepared. Furthermore, a photosensitive composition for the black matrix may be prepared.

For example, first, the visible-light shielding layer composition is applied to form a coating film, which is then exposed to light, developed, and cured by heating to form a patterned visible-light shielding layer. Next, a composition for a colored layer of a first color is applied to form a coating film, which is then exposed to light, developed, and cured by heating to form the colored layer of the first color. By repeating the same process for the colored layer compositions of the second and third colors, three colored layers are formed. Next, the near-infrared light shielding layer composition is applied to form a coating film, which is then exposed to light, developed, and cured by heating to form a patterned near-infrared light shielding layer on the colored layers, thereby obtaining the color filter.

The coating method can be appropriately selected from known methods such as spray coating, dip coating, bar coating, roll coating, and spin coating.

The exposure method may involve exposing the coating film through a mask having a predetermined pattern using, as the light source, an ultraviolet light source such as a low-pressure mercury lamp, a high-pressure mercury lamp, or a metal halide lamp, or an electron beam. The uncured photosensitive composition can be removed using a developer such as an alkaline developer to obtain a patterned filter.

The heat curing temperature is preferably 120°C or lower, and more preferably 100°C or lower, from the perspective of protecting the organic EL layer. By using the photosensitive composition, the coating film can be sufficiently cured even at a low temperature of 120°C or lower.

The thickness of each color filter is preferably 0.1 to 5 µm, more preferably 0.5 to 2.0 µm, and even more preferably 1.0 to 2.0 µm.

As a result, an organic EL display device with high brightness, high resolution, and reduced drive power consumption can be obtained.

### [Manufacturing Examples of Visible-Light Shielding Layer and Near-Infrared Light Shielding Layer]

The visible-light shielding layer and the near-infrared light shielding layer will be described below with reference to embodiments of manufacturing examples. In the manufacturing examples, "parts" and "%" represent "parts by weight" and "% by weight", respectively. Furthermore, "PGMAC" means methoxypropyl acetate. The weight-average molecular weight (Mw) of resin is measured as follows.

### (Weight Average Molecular Weight (Mw) of Resin)

The weight-average molecular weight (Mw) of a resin is the polystyrene-equivalent weight-average molecular weight (Mw) measured using a TSKgel column (manufactured by Tosoh Corporation), a GPC device equipped with an RI detector (HLC-8120GPC, manufactured by Tosoh Corporation), and THF as the mobile phase.

### [Production of Visible-Light Shielding Layer Composition]

### <Production of Binder Resin Solution>

### (Preparation of Binder Resin Solution 1)

A reaction vessel, including a separable four-necked flask and a thermometer, a cooling tube, a nitrogen gas inlet tube, a dropping tube, and a stirrer attached thereto, was charged with 196 parts of cyclohexanone. After raising the temperature to 80°C and replacing the atmosphere in the reaction vessel with nitrogen, a mixture of 20.0 parts of benzyl methacrylate, 17.2 parts of n-butyl methacrylate, 12.9 parts of 2-hydroxyethyl methacrylate, 12.0 parts of methacrylic acid, 20.7 parts of paracumylphenol ethylene oxide-modified acrylate ("ARONIX M110" manufactured by Toagosei Co., Ltd.), and 1.1 parts of 2,2'-azobisisobutyronitrile was added dropwise via the dropping tube over 2 hours to effect polymerization. After completion of the dropwise addition, the reaction was continued for an additional 3 hours and then terminated by cooling.

After cooling to room temperature, approximately 2 parts of the resin solution was sampled and dried by heating at 180°C for 20 minutes to measure the nonvolatile content. PGMAC was added so that the nonvolatile content became 20% by weight, thereby preparing a binder resin solution 1. Note that the weight-average molecular weight (Mw) was 26,000.

### <Method for Producing Micronized Pigment>

### (Blue Micronized Pigment (B1))

200 parts of a phthalocyanine-based blue pigment, C. I. Pigment Blue 15:6 ("LIONOL BLUE ES" manufactured by Toyo Color Co., Ltd., hereinafter referred to as PB15:6), 1,400 parts of sodium chloride, and 360 parts of diethylene glycol were charged into a stainless steel 1-gallon kneader (manufactured by Inoue Seisakusho Co., Ltd.) and kneaded at 80°C for 6 hours. Next, this kneaded product was added to 8,000 parts of warm water and stirred for 2 hours while heating to 80°C to form a slurry. After repeated filtering and washing with water to remove sodium chloride and diethylene glycol, the mixture was dried at 85°C for one day to obtain a blue micronized pigment (B1).

### (Yellow Micronized Pigment (Y1))

100 parts of an isoindolinone-based yellow pigment, C. I. Pigment Yellow 139 ("PALIOTOL YELLOW D1819" manufactured by BASF, hereinafter referred to as PY139), 800 parts of ground salt, and 180 parts of diethylene glycol were charged into a stainless steel 1-gallon kneader (manufactured by Inoue Seisakusho Co., Ltd.) and kneaded at 70°C for 4 hours. This mixture was added to 3,000 parts of warm water and stirred for about 1 hour with a high-speed mixer while heating to about 80°C to form a slurry. After repeated filtering and washing with water to remove the salt and solvent, the mixture was dried at 80°C for 24 hours to obtain 96 parts of a yellow micronized pigment (Y1).

### (Micronized Violet Pigment (V1))

200 parts of a dioxazine-based violet pigment, C. I. Pigment Violet 23 ("LIONOGEN VIOLET RL" manufactured by Toyo color Co., Ltd., hereinafter referred to as PV23), 1,400 parts of sodium chloride, and 360 parts of diethylene glycol were charged into a stainless steel 1-gallon kneader (manufactured by Inoue Seisakusho Co., Ltd.) and kneaded at 80°C for 6 hours. Next, this kneaded product was added to 8,000 parts of warm water and stirred for 2 hours while heating to 80°C to form a slurry. After repeated filtering and washing with water to remove sodium chloride and diethylene glycol, the mixture was dried at 85°C for one day to obtain a dioxazine-based violet micronized pigment (V1).

### <Method for Producing Pigment Dispersion>

### (Preparation of Pigment Dispersion (BP-1))

The following components were stirred and mixed to form a uniform mixture, and then dispersed for 5 hours using a paint shaker SO400 (manufactured by Skandex) using zirconia beads having a diameter of 1 mm. Then, 30.0 parts of methoxypropyl acetate was added, and the mixture was filtered through a 5 µm filter to obtain a pigment dispersion (BP-1).
Blue micronized pigment (B1)); 14.0 parts
Binder resin solution 1: 30.0 parts
Methoxypropyl acetate: 26.0 parts

### (Preparation of Pigment Dispersions (YP1 and VP-1))

Pigment dispersions (YP1 and VP-1) were obtained in the same manner as the pigment dispersion (BP-1), except that the compositions and blending amounts (parts by weight) were changed to those shown in Table 1. The units of blending amounts in the table are parts by mass.

**[Table 1]**

| Table 1 | BP-1 | YP-1 | VP-1 |
|---|---|---|---|
| Micronized pigment type | B1 | Y1 | V1 |
| | PB15:6 | PY139 | PV23 |
| Micronized pigment | 14.0 | 14.0 | 14.0 |
| Binder resin solution 1 | 30.0 | 30.0 | 30.0 |
| Methoxypropyl acetate | 56.0 | 56.0 | 56.0 |
| Total | 100.0 | 100.0 | 100.0 |

### <Production of Visible-Light Shielding Layer Composition (BLK-1)>

The following components (100 parts in total) were stirred and mixed to form a uniform mixture, and then filtered through a 1.0 µm filter to obtain a visible-light shielding layer composition (BLK-1).
Pigment dispersion (BP-1): 22.5 parts
Pigment dispersion (VP-1): 17.4 parts
Pigment dispersion (YP-1): 24.4 parts
Binder resin solution 1: 0.9 parts
Photopolymerizable monomer A: 4.2 parts
   "ARONIX M-309" manufactured by Toagosei Co., Ltd.
Photoinitiator A: 0.7 parts
   "Irgacure OXE-02" manufactured by BASF
Leveling agent: 1.0 part
   "FZ-2122" manufactured by Dow Toray Co., Ltd. (a solution prepared by diluting 1 part (non-volatile content 100% by weight) with 99 parts of cyclohexanone)
Solvent: 28.9 parts
   Methoxypropyl acetate

### [Production of Near-Infrared Light Shielding Layer Composition]

### <Method for Producing Near-Infrared-Light-Absorbing Dye (E)>

400 parts of toluene were mixed with 40.0 parts of 1,8-diaminonaphthalene, 25.1 parts of cyclohexanone, and 0.087 parts of p-toluenesulfonic acid monohydrate, and the mixture was heated and stirred in a nitrogen gas atmosphere to perform reaction under reflux for 3 hours. The water produced during the reaction was removed from the system by azeotropic distillation.

After completion of the reaction, the toluene was distilled off to obtain a dark brown solid, which was extracted with acetone and then purified by recrystallization from a mixed solvent of acetone and ethanol. The obtained brown solid was dissolved in a mixed solvent of 240 parts of toluene and 160 parts of n-butanol. Then, 13.8 parts of 3,4-dihydroxy-3-cyclobutene-1,2-dione was added, and the mixture was heated and stirred in a nitrogen gas atmosphere, and reacted under reflux for 8 hours. The water produced during the reaction was removed from the system by azeotropic distillation.

After completion of the reaction, the solvent was distilled off, and 200 parts of hexane was added to the resulting reaction mixture while stirring. The resulting black-brown precipitate was filtered off, washed successively with hexane, ethanol, and acetone, and dried under reduced pressure to obtain 61.9 parts (yield: 92%) of a near-infrared-light-absorbing dye (E). The identification of compounds was carried out by mass spectrometry using TOF-MS.

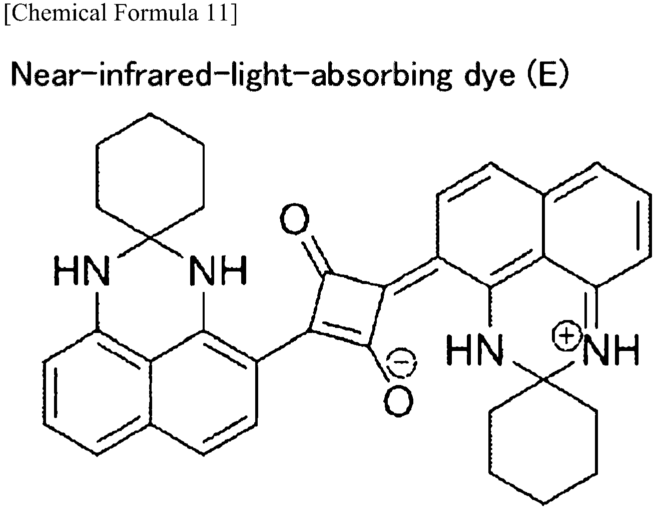

### <Method for Producing Resin-Type Dispersant (F)>

### (Resin-type dispersant (F) solution): Graft copolymer

A reaction vessel provided with a gas inlet tube, a thermometer, a condenser, and a stirrer was charged with 150 parts of PGMAC and 100 parts of n-butyl acrylate, and the atmosphere was replaced with nitrogen gas. The inside of the reaction vessel was heated to 80°C, and a solution of 0.5 parts of 2,2'-azobisisobutyronitrile dissolved in 4 parts of 2-mercaptoethanol was added, and then reacted for 10 hours. After confirming that 95% or more had reacted by measuring the nonvolatile content, a reaction product (dispersant 1a) having a number-average molecular weight of 3,900 and a weight-average molecular weight of 7,900 was obtained.

7.9 parts of 2-methacryloyloxyethyl isocyanate, 0.05 parts of methyldibutyltin dilaurate, and 0.05 parts of methylhydroquinone were added to the reaction product, and the reaction vessel was heated to 100°C to allow the mixture to react for 4 hours. Then, the mixture was cooled to 40°C to obtain a reaction product (resin-type dispersant 1b solution).

A reaction vessel provided with a gas inlet tube, a condenser, a stirring blade, and a thermometer was charged with 122 parts of PGMAC, and the temperature was raised to 100°C while replacing the atmosphere with nitrogen. A dropping tank was charged with 262.5 parts of the reaction product (resin-type dispersant 1b solution), 150 parts of pentamethylpiperidyl methacrylate (ADK STAB LA-82 manufactured by ADEKA CORPORATION), 10 parts of hydroxyethyl methacrylate, and 4 parts of 2,2'-azobis(2,4-dimethylbutyronitrile), and the mixture was stirred until homogeneous. The mixture was then added dropwise to the reaction tank over 2 hours to cause the reaction. The reaction was continued at the same temperature for an additional 3 hours, and then cooled to terminate the reaction. After performing sampling to check the nonvolatile content, PGMAC was added to adjust the nonvolatile content to 40% by mass. In this way, a resin-type dispersant (F) solution was obtained, which was a graft copolymer having an amine value per nonvolatile content of 42 mg KOH/g, a weight-average molecular weight (Mw) of 23,500, and a tertiary amino group.

### <Method for Producing Binder Resin (G) Solution>

A reaction vessel, including a separable four-necked flask and a thermometer, a cooling tube, a nitrogen gas inlet tube, and a stirrer attached thereto, was charged with 70.0 parts of cyclohexanone. After raising the temperature to 80°C and replacing the atmosphere in the reaction vessel with nitrogen, a mixture of 12.4 parts of n-butyl methacrylate, 4.6 parts of 2-hydroxyethyl methacrylate, 4.3 parts of methacrylic acid, 7.3 parts of paracumylphenol ethylene oxide-modified acrylate ("ARONIX M110" manufactured by Toagosei Co., Ltd.) (weight ratio of n-butyl methacrylate / 2-hydroxyethyl methacrylate / methacrylic acid / paracumylphenol ethylene oxide-modified acrylate being 10.5/15.5/17.1/25.0), and 0.7 parts of 2,2'-azobisisobutyronitrile was added dropwise over 2 hours to cause the reaction. After completion of the dropwise addition, the reaction was continued for additional 3 hours and then terminated by cooling. After cooling to room temperature, about 2 g of the resin solution was sampled and dried by heating at 180°C for 20 minutes, and the nonvolatile content was measured. Propylene glycol monoethyl ether acetate was added so that the nonvolatile content became 20% by weight, thereby preparing a binder resin

### (G) solution having an acid value of 110 mgKOH/g and a weight-average molecular weight (Mw) of 10,000 b.

### (Near-Infrared-Light-Shielding Dispersion (E-1))

A mixture having the following composition was stirred and mixed to a uniform consistency, and then dispersed in an Eiger mill using zirconia beads having a diameter of 0.5 mm for 3 hours. The dispersion was then filtered through a 0.5 µm filter to prepare a near-infrared-light-shielding dispersion (E-1) having a nonvolatile content of 20.0%.
Near-infrared-light-absorbing dye (E)): 12. 5 parts
Resin-type dispersant (F) solution: 9.5 parts
Binder resin (G) solution: 18.5 parts
Methoxypropyl acetate: 59.5 parts

### <Production of Near-Infrared Light Shielding Layer Composition>

The following components were stirred and mixed to form a uniform mixture, and then filtered through a 1.0 µm filter to obtain a near-infrared light shielding layer composition (IR-1).
Near-infrared-light-shielding dispersion (E-1): 27.5 parts
Binder resin (G) solution: 17.8 parts

Photopolymerizable monomer ("ARONIX M-309" manufactured by Toagosei Co., Ltd.): 6.8 parts Photoinitiator (an oxime ester-based photoinitiator "OXE-02" manufactured by BASF): 0.6 parts Leveling agent

"FZ-2122" manufactured by Dow Toray Co., Ltd. (a solution prepared by diluting 1 part (non-volatile content 100% by weight) with 99 parts of cyclohexanone)
Solvent: 1.0 part
Methoxypropyl acetate: 43.3 parts

### [Production Example 1: Preparation of Visible-Light Shielding Layer]

The obtained visible-light shielding layer composition (BLK-1) was applied onto a glass substrate having a length of 100 mm, a width of 100 mm, and a thickness of 0.7 mm using a spin coater, and then heated at 100°C for 15 minutes and allowed to cool, thereby obtaining a test substrate 1 having a film thickness of 1.0 µm.

### <Measurement of Light Transmittance of Visible-Light Shielding Layer>

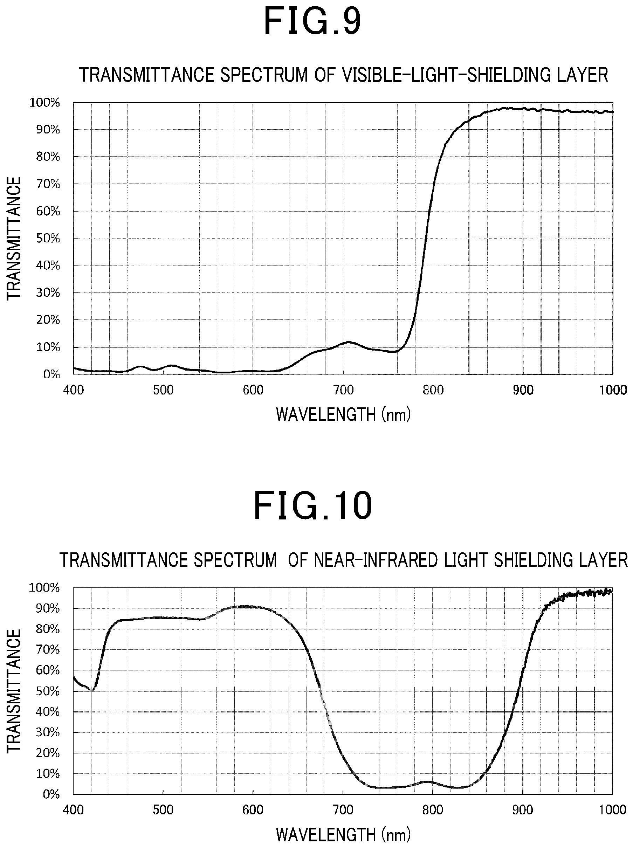

The light transmittance of the obtained test substrate 1 in the wavelength range of 400 to 1000 nm was measured using a microspectrophotometer ("U-3900" manufactured by Hitachi High-Tech Science Corporation). Fig. 9 shows the spectral data. In addition, Table 2 shows the maximum light transmittance in the wavelength range of 400 to 620 nm (Tmax(400 to 620 nm)), the maximum light transmittance in the wavelength range of 620 to 730 nm (Tmax(620 to 730 nm)), and the minimum light transmittance in the wavelength range of 830 to 1000 nm (Tmin(830 to 1000 nm)).

**[Table 2]**

| Table 2 | Measured value |
|---|---|
| Maximum light transmittance from 400 to 620 nm | 3.3% |
| Maximum light transmittance from 620 to 730 nm | 11.9% |
| Minimum light transmittance from 830 to 1000 nm | 91.1% |

### [Production Example 2: Preparation of Near-Infrared-Light-Absorbing Layer]

The obtained near-infrared light shielding layer composition (IR-1) was applied onto a glass substrate having a length of 100 mm, a width of 100 mm, and a thickness of 0.7 mm using a spin coater, and then heated at 100°C for 15 minutes and allowed to cool, thereby obtaining a test substrate 2 having a film thickness of 0.7 µm.

### <Measurement of Light Transmittance of Near-Infrared-Light-Absorbing Layer>

The light transmittance of the obtained test substrate 2 in the wavelength range of 400 to 1000 nm was measured using a microspectrophotometer ("U-3900" manufactured by Hitachi High-Tech Science Corporation). Fig. 10 shows the spectral data. In addition, Table 3 shows the average light transmittance, the maximum absorption wavelength, and the transmittance at that wavelength in the wavelength range of 450 to 600 nm.

**[Table 3]**

| Table 3 | Measured value |
|---|---|
| Average light transmittance from 450 to 600 nm | 86.5% |
| Maximum absorption wavelength | 825nm |
| Transmittance at maximum absorption wavelength | 3.1% |

As shown in Table 2 and Fig. 9, the visible-light shielding layer of Production Example 1 has good visible-light-shielding properties and near-infrared transmittance. Furthermore, as shown in Table 3 and Fig. 10, the near-infrared light shielding layer of Production Example 2 has good near-infrared-light-shielding properties and visible light transmittance. The organic EL display device of the present disclosure combines such a visible-light shielding layer with a near-infrared light shielding layer to form a color filter with a layer configuration as shown in Figs. 1 to 5 , thereby suppressing the incidence of light that causes noise in the near-infrared light receiving portion while maintaining the high brightness, high resolution, and color reproducibility as a display device.

### [Industrial Applicability]

The organic EL display device of the present disclosure has high brightness, high resolution, good color reproducibility, and can be reduced in driving power consumption, size, and weight. Therefore, it is suitable for micro-OLEDs, and can be suitably used as a display device for electronic devices such as smart glasses, head-mounted displays, and electronic viewfinders.

This application claims priority based on Japanese Patent Application No. 2023-149493, filed on September 14, 2023, the disclosure of which is incorporated herein by reference in its entirety.

### [Reference Signs List]

- 4: ... Colored layer;
- 4B: ... Blue layer;
- 4G: ... Green layer;
- 4R: ... Red layer;
- 5: ... Visible-light shielding layer;
- 6: ... Near-infrared light shielding layer;
- 7: ... Colored layer;
- 8: ... Light shielding layer;
- 10: ... Substrate;
- 20: ... Coating film;
- 21: ... Near-infrared light receiving portion;
- 22: ... Near-infrared light emitting portion;
- 30: ... Organic EL layer;
- 40: ... Color filter;
- 50: ... Wiring layer;
- 61: ... Near-infrared light;
- 62: ... Visible light;
- 63: ... Near-infrared light;
- 64: ... Near-infrared light; and
- 100: ... Organic EL display device.

## Claims

1. An organic EL display device comprising, on a substrate, a near-infrared light receiving portion, a lower electrode, a light emitting layer, a transparent electrode, and a color filter in this order,
wherein the color filter has a patterned colored layer and a visible-light shielding layer provided on the near-infrared light receiving portion, and
a near-infrared light shielding layer is provided on the colored layer, the near-infrared light shielding layer being located between the colored layer and the transparent electrode or integrated with the colored layer

2. The organic EL display device according to claim 1, further comprising a near-infrared light emitting portion between the substrate and the lower electrode, wherein the color filter has a visible-light shielding layer provided on the near-infrared light emitting portion.

3. The organic EL display device according to claim 1, wherein the near-infrared light shielding layer is provided on the colored layer.

4. The organic EL display device according to claim 1, wherein the thickness of the visible-light shielding layer is greater than the total thickness of the colored layer and the near-infrared light shielding layer.

5. The organic EL display device according to claim 1, wherein the visible-light shielding layer has a maximum light transmittance of 5% or less in the wavelength range of 400 to 620 nm, a maximum light transmittance of 13% or less in the wavelength range of 620 to 730 nm, and a minimum light transmittance of 85% or more in the wavelength range of 830 to 1000 nm.

6. The organic EL display device according to claim 3, wherein the near-infrared light shielding layer has an average light transmittance of 80% or more in the wavelength range of 450 to 600 nm, a maximum absorption wavelength in the wavelength range of 780 to 1000 nm, and a light transmittance of 10% or less at the maximum absorption wavelength.

7. The organic EL display device according to claim 1, wherein the visible-light shielding layer is a cured product of a visible-light shielding layer composition containing an organic pigment (A), a binder resin (B), a photoinitiator (C), and a photopolymerizable compound (D),
the organic pigment (A) contains a blue pigment, a yellow pigment, and a violet pigment,
and
the content of the blue pigment is 32 to 45% by weight, the content of the yellow pigment is 30 to 40% by weight, and the content of the violet pigment is 20 to 30% by weight, relative to the organic pigment (A).

8. The organic EL display device according to claim 1, wherein the near-infrared light shielding layer is a cured product of a near-infrared light shielding layer composition containing a near-infrared light absorbing dye (E) represented by the following general formula (1), a resin-type dispersant (F) having an amine value of 20 mgKOH/g to 200 mgKOH/g, and a binder resin (G) having a weight-average molecular weight of 5,000 to 40,000 and an acid value of 100 mgKOH/g to 130 mgKOH/g: 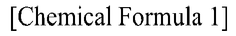 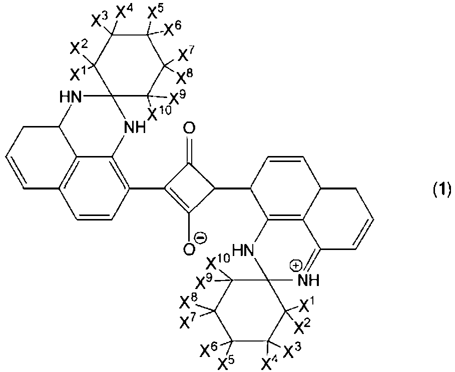 where X¹ to X¹⁰ each independently represent a hydrogen atom, an alkyl group which may have one or more substituents, an alkenyl group which may have one or more substituents, an aryl group which may have one or more substituents, an aralkyl group which may have one or more substituents, an alkoxy group which may have one or more substituents, an aryloxy group which may have one or more substituents, an amino group, a substituted amino group, a sulfo group, -SO₂NR¹R², -COOR¹, -CONR¹R², a nitro group, a cyano group, or a halogen atom, X¹ to X¹⁰ may be bonded to each other to form a ring, and R¹ and R² each independently represent a hydrogen atom or an alkyl group which may have one or more substituents.

9. A method for manufacturing an organic EL display device according to any one of claims 1 to 8, wherein the colored layer, the visible-light shielding layer, and the near-infrared light shielding layer are formed at 120°C or lower.

10. The method for manufacturing an organic EL display device according to claim 9, comprising preparing a laminated substrate including a substrate and a near-infrared light receiving portion, a lower electrode, a light emitting layer, and a transparent electrode provided on the substrate, and
forming a coating film of a colored layer composition on the laminated substrate.
